# EUROPÄISCHE PATENTSCHRIFT

(11) **EP 3 921 658 B1**
(45) Veröffentlichungstag und Bekanntmachung des Hinweises auf die Patenterteilung: **05.04.2023**
(21) Anmeldenummer: 19703705.4
(22) Anmeldetag: 06.02.2019
(51) Int. Cl.: G01R 31/00, G01R 31/08

(54) **VERFAHREN UND PRÜFVORRICHTUNG**
METHOD AND TESTING DEVICE
PROCÉDÉ ET DISPOSITIF DE CONTRÔLE

(43) Veröffentlichungstag der Anmeldung: 15.12.2021
(73) Patentinhaber: Lisa Dräxlmaier GmbH, 84137 Vilsbiburg (DE)
(72) Erfinder: FRANKE, Michael, 84144 Geisenhausen (DE); KAPPL, Andreas, 84034 Landshut (DE)
(86) Internationale Anmeldenummer: PCT/EP2019/052845
(87) Internationale Veröffentlichungsnummer: WO 2020/160761

(56) Entgegenhaltungen:
- CN-A- 107 766 879
- DE-A1-102017 110 620
- US-A1- 2015 081 599

## Beschreibung

### Technisches Gebiet

Die vorliegende Erfindung betrifft eine Prüfvorrichtung zur Prüfung eines Leitungssatzes. Ferner betrifft die vorliegende Erfindung ein entsprechendes Verfahren.

### Stand der Technik

Die vorliegende Erfindung wird im Folgenden hauptsächlich in Verbindung mit Bordnetzen von Fahrzeugen beschrieben. Es versteht sich, dass die vorliegende Erfindung auch mit anderen elektrischen Netzen eingesetzt werden kann.

In modernen Fahrzeugen wird eine Vielzahl elektrischer und elektronischer Komponenten verbaut. Solche Komponenten können z.B. Steuergeräte sein, die Komfortfunktionen bzw. Fahrerassistenzfunktionen bereitstellen. In einem modernen Fahrzeug kann eine Vielzahl solcher Steuergeräte verbaut sein. Üblicherweise werden die Steuergeräte über einen Leitungssatz bzw. Kabelsatz elektrisch miteinander verbunden. Ein solcher Leitungssatz bzw. Kabelsatz kann dabei unterschiedliche elektrische Netzwerke mit Versorgungsleitungen und Datenleitungen aufweisen.

Um eine einwandfreie Funktion des späteren Fahrzeugs sicherzustellen, müssen die Leitungs- bzw. Kabelsätze geprüft werden. Insbesondere bei den Datenleitungen bzw. die Netzwerke aus Datenleitungen und weiteren Komponenten ist es zunehmend wichtig, deren Eigenschaften bei hohen Frequenzen zu prüfen. Zusätzlich zur reinen Anwesenheits- bzw. Durchgangsprüfung können Qualitätskriterien wie z.B. die Impedanz in Abhängigkeit des Orts und S-Parameter geprüft werden.

Für Einzelleitungen kann z.B. die ortsaufgelöste Impedanzkurve erfasst und ausgewertet werden. Allerdings kann dieses Verfahren bei Netzwerken aus mehreren verbundenen Datenleitungen und möglicherweise auch weiteren elektrischen bzw. elektronischen Komponenten nicht effizient angewendet werden. Bei solchen Netzwerken überlagert sich eine Vielzahl von Reflexionen, was dazu führt, dass einzelne Störstellen in der erfassten Messkurve nicht direkt und eindeutig identifiziert werden können.

Die CN 107 766 879 A offenbart ein MLP-Diagnoseverfahren, das auf der Extraktion charakteristischer Informationen für Stromnetzfehlerursachen basiert. Die DE 10 2017 110 620 A1 offenbart eine Fehlerdiagnose in einem elektrischen Netzwerk. Die US 2015 / 0 81 599 A1 offenbart das genaue Bestimmen von Fehlerbereichen eines elektrischen Geräts.

### Beschreibung der Erfindung

Eine Aufgabe der Erfindung ist es daher, unter Einsatz konstruktiv möglichst einfacher Mittel eine Möglichkeit zum prüfen komplexer Leitungsnetzwerke zu ermöglichen.

Die Aufgabe wird durch die Gegenstände der unabhängigen Ansprüche gelöst. Vorteilhafte Weiterbildungen der Erfindung sind in den abhängigen Ansprüchen, der Beschreibung und den begleitenden Figuren angegeben. Insbesondere können die unabhängigen Ansprüche einer Anspruchskategorie auch analog zu den abhängigen Ansprüchen einer anderen Anspruchskategorie weitergebildet sein.

Ein erfindungsgemäßes Verfahren dient der Prüfung eines Netzwerks mit einer Anzahl, also einem oder mehreren, von Netzwerkabschnitten, insbesondere in einem Leitungssatz mit einer Anzahl, also einem oder mehreren, solcher Netzwerke. Das Verfahren weist die folgenden Schritte auf: Aufnehmen von Trainingsmesswerten für eine Anzahl, also einem oder mehreren, von Referenznetzwerken, wobei die Referenznetzwerke dem zu prüfenden Netzwerk entsprechen, Vorverarbeiten der aufgenommenen Trainingsmesswerte zum Eliminieren von Datenfehlern in den Trainingsmesswerten, Trainieren eines ersten Klassifikationssystems mit den Trainingsmesswerten, wobei das erste Klassifikationssystem auf mindestens einem Algorithmus aus dem Bereich des maschinellen Lernens basiert und ausgebildet ist, ein Netzwerk entweder als fehlerfrei oder fehlerbehaftet zu klassifizieren, Trainieren eines zweiten Klassifikationssystems mit den Trainingsmesswerten, wobei das zweite Klassifikationssystem auf mindestens einem Algorithmus aus dem Bereich des maschinellen Lernens basiert und ausgebildet ist, einen fehlerbehafteten Netzwerkabschnitt eines Netzwerks zu klassifizieren, Aufnehmen von Prüfmesswerten für das zu prüfende Netzwerk, Vorverarbeiten der aufgenommenen Prüfmesswerte zum Eliminieren von Datenfehlern in den Trainingsmesswerten, Klassifizieren des zu prüfenden Netzwerks anhand der aufgenommenen Prüfmesswerte mit dem trainierten ersten Klassifikationssystem als fehlerfrei oder fehlerbehaftet, und Klassifizieren des fehlerbehafteten Netzwerkabschnitts des zu prüfenden Netzwerks mit dem trainierten zweiten Klassifikationssystem, wenn das zu prüfende Netzwerk von dem trainierten ersten Klassifikationssystem als fehlerbehaftet klassifiziert wurde.

Eine erfindungsgemäße Prüfvorrichtung dient der Prüfung eines Netzwerks mit einer Anzahl, also einem oder mehreren, von Netzwerkabschnitten, insbesondere in einem Leitungssatz mit einer Anzahl, also einem oder mehreren, solcher Netzwerke. Die Prüfvorrichtung weist auf: eine erste Datenerfassungseinrichtung, welche ausgebildet ist, Trainingsmesswerte für eine Anzahl, also einem oder mehreren, von Referenznetzwerken aufzunehmen, wobei die Referenznetzwerke dem zu prüfenden Netzwerk entsprechen, eine Recheneinrichtung, welche ausgebildet ist, die aufgenommenen Trainingsmesswerte zum Eliminieren von Datenfehlern in den Trainingsmesswerten vorzuverarbeiten, ein erstes Klassifikationssystem, welches auf mindestens einem Algorithmus aus dem Bereich des maschinellen Lernens basiert und ausgebildet ist, ein Netzwerk entweder als fehlerfrei oder fehlerbehaftet zu klassifizieren, wobei die Recheneinrichtung ferner ausgebildet ist, das erste Klassifikationssystem mit den Trainingsmesswerten zu trainieren, ein zweites Klassifikationssystem, welches auf mindestens einem Algorithmus aus dem Bereich des maschinellen Lernens basiert und ausgebildet ist, einen fehlerbehafteten Netzwerkabschnitt eines Netzwerks zu klassifizieren, wobei die Recheneinrichtung ferner ausgebildet ist, das zweite Klassifikationssystem mit den Trainingsmesswerten zu trainieren, eine zweite Datenerfassungseinrichtung, welche ausgebildet ist, Prüfmesswerte für das zu prüfende Netzwerk aufzunehmen, mit einer Prüfsteuereinrichtung, welche ausgebildet ist, die aufgenommenen Prüfmesswerte zum Eliminieren von Datenfehlern in den Trainingsmesswerten vorzuverarbeiten, wobei die Prüfsteuereinrichtung ferner ausgebildet ist, das zu prüfende Netzwerk anhand der aufgenommenen Prüfmesswerte mit dem trainierten ersten Klassifikationssystem als fehlerfrei oder fehlerbehaftet zu klassifizieren, und wobei die Prüfsteuereinrichtung ferner ausgebildet ist, den fehlerbehafteten Netzwerkabschnitt des zu prüfenden Netzwerks mit dem trainierten zweiten Klassifikationssystem zu klassifizieren, wenn das zu prüfende Netzwerk von dem trainierten ersten Klassifikationssystem als fehlerbehaftet klassifiziert wurde.

Die vorliegende Erfindung basiert auf der Erkenntnis, dass es mit herkömmlichen Methoden nicht möglich ist, komplexe Netzwerke in Leitungssätzen effektiv zu prüfen.

In modernen Fahrzeugen z.B. werden in elektrischen Netzwerken zunehmend Hochfrequenzdatenleitungen, die nicht lediglich eine Punkt-zu-Punkt Verbindung herstellen, eingesetzt. Solche elektrischen Netzwerke können z.B. auch eine Busstruktur mit Stichleitungen oder eine Sternstruktur mit einem zentralen Knoten aufweisen.

Grundsätzlich ist der Informationsaustausch zwischen den elektronischen Steuergeräten in den letzten Jahren förmlich explodiert. Die Anzahl der Steuergeräte ist gestiegen und die für neuartige Services zusätzlich notwendige Vernetzung erhöht die Komplexität. Kabellose Übertragungen haben bis heute aufgrund verschiedener Gründe keinen Einzug in das Bordnetz gefunden: Zahlreiche abschirmende Metallstrukturen innerhalb des Fahrzeugs, erwartete Probleme im Bereich der elektromagnetischen Verträglichkeit oder die heutzutage oft diskutierten potentiellen Gefahren durch Elektrosmog. Aus diesem Grund ist es umso wichtiger, dass die kabelbasierten hoch frequentierten Datenübertragungen möglichst störungsfrei und zuverlässig erfolgen. Zwei der möglichen Leitungsarten sind das Koaxialkabel und das UTP (Unshielded Twisted Pair) - Kabel.

Koaxialkabel bestehen aus einem massiven Innenleiter aus Kupfer, einem isolierenden Dielektrikum (elektrisch nichtleitendende Substanz), einem Schirm, der gleichzeitig als Rückleiter fungiert, und einem aufgespritzten Mantel, der das Kabel von äußeren Einflüssen schützt. Das Koaxialkabel weist aufgrund der abschirmenden Bauform günstige Übertragungseigenschaften für den Hochfrequenzbereich auf, ist aber in der Herstellung relativ aufwendig und somit teuer. Aus diesem Grund werden in vielen Fällen UTP-Kabel verwendet, Kabel mit verdrillten Paaren von Leitungen ohne explizite Abschirmung. Diese sind günstig in der Herstellung und haben zudem zwei entscheidende Vorteile. Obwohl die Bauweise keine Abschirmung zur Verfügung stellt, weist sie eine hohe Störfestigkeit auf. Auf den beiden Leitungen werden die Signale jeweils gegeneinander invertiert eingesteuert, äußere Störungen hingegen wirken gleichermaßen auf beide Leitungen. Es liegt also eine differentielle Signalübertragung vor. Folglich verdoppelt sich die Amplitude des eingesteuerten Signals und die Störsignale werden im Empfänger durch Subtraktion eliminiert.

Bisherige Verfahren der optischen Prüfung einer Messkurve für z.B. eine Datenleitung können bei komplexen Netzwerken aber nicht genutzt werden. In komplexeren Netzwerken aus UTP-Leitungen führt insbesondere die Überlagerung einer Vielzahl von Reflexionen in der Messung dazu, dass charakteristische Kurvenmerkmale nicht einzeln identifiziert und in dem Netzwerk verortet werden können.

Je höher allerdings die Datenübertragungsraten, welche für moderne Anwendungen wie das autonome Fahren nötig sind, desto wichtiger ist die Konformität der Netzwerke, um eine fehlerfreie Datenübertragung gewährleisten zu können.

Entsprechend stellt die vorliegende Erfindung eine Möglichkeit bereit, elektrische Netzwerke mit Hilfe von Verfahren bzw. Algorithmen aus dem Bereich des maschinellen Lernens zu prüfen.

Dazu werden Trainingsmesswerte für eines oder mehrere von Referenznetzwerken aufgenommen. Unter dem Begriff "Referenznetzwerk" ist dabei jeweils ein Netzwerk zu verstehen, dessen Eigenschaft bereits auf Konformität geprüft wurde, welches sich also in einem definierten Zustand befindet, also z.B. fehlerfrei ist. Es versteht sich, dass diese Prüfung z.B. im Vorfeld der Aufnahme von Trainingsmesswerten erfolgen kann. Da es sich hierbei für jedes der zu prüfenden Netzwerke um eine einmalige Prüfung der Referenznetzwerke handelt, können hierfür aufwändigere Verfahren, z.B. auch unter Laborbedingungen, genutzt werden. Die eigentliche Prüfung der zu prüfenden Netzwerke z.B. in einer Serienproduktion kann dann sehr effizient mit Hilfe der vorliegenden Erfindung erfolgen.

Für die Aufnahme der Trainingsmesswerte, wie auch die spätere Aufnahme der Prüfmesswerte, kann z.B. die Zeitbereichsreflektometrie genutzt werden. Es versteht sich, dass jedes andere geeignete Verfahren ebenfalls genutzt werden kann. Bei der Zeitbereichsreflektometrie werden Spannungsverläufe über die Zeit gemessen und deren Verläufe als Basis für eine Analyse genutzt.

Grundsätzlich versucht die Zeitbereichsreflektometrie Fehler entlang des verwendeten Netzwerkes anhand des entsprechenden Spannungsverlaufs zu detektieren. In den Spannungsverläufen schlagen sich eingespeiste Spannungen und Reflektionen entlang des Netzwerks auf Grund von Impedanzänderungen nieder.

Bei verdrillten Leitungen mit einem offenen Ende ist der Widerstand unendlich. Für den Spannungsreflexionsfaktor ergibt sich durch eine Grenzwertberechnung der Wert 1, die vollständige positive Reflexion. Bei einem Kurzschluss ist der Widerstand nahezu 0, sodass sich ein Faktor von -1 ergibt, die vollständige negative Reflexion. Weicht die Abschlussimpedanz von den eben genannten Sonderfällen ab, sind Teilreflexionen detektierbar. Derselbe Effekt tritt auf, wenn sich die Impedanz entlang der Leitung ändert und nicht durchgehend konstant ist. Änderungen treten beispielsweise auf, wenn sich Verdrillungen lösen, die Isolationen beschädigt sind, die Struktur an sich nicht konstant produziert wurde oder gar die Leitung geknickt oder abgerissen wurde. Zur Durchführung der Zeitbereichsreflektometrie wird eine Spannungsstufe an einem Eingang des Netzwerks angelegt, die sich entlang des Netzwerks ausbreitet. Je nachdem wie die Leitungsenden abgeschlossen sind oder sich Impedanzen entlang des Netzwerks ändern, treten unterschiedliche Reflexionen auf, die an der Stelle der Einspeisung anhand eines Oszilloskops aufgenommen werden. Dieser für das Leitungsnetzwerk entstehende charakteristischer Spannungsverlauf (Summe der ausgehenden und einkommenden Spannung) lässt Rückschlüsse auf dessen Beschaffenheit ziehen. Dieser Spannungsverlauf bzw. die entsprechenden Trainings- und Prüfmessdaten werden im weiteren Verlauf auch als elektrischer Fingerabdruck bezeichnet.

Die vorliegende Erfindung sieht vor, dass mit Hilfe der Trainingsdaten ein erstes Klassifikationssystem und ein zweites Klassifikationssystem trainiert werden.

Allerdings liegt ein wesentlicher Aspekt der vorliegenden Erfindung in der Vorverarbeitung der aufgenommen Trainingsmesswerte. Die Aufnahme der Trainingsmesswerte liefert für die Referenznetzwerke jeweils einen elektrischen Fingerabdruck in Rohform, also die unveränderten Trainingsmesswerte.

Bei der Konzeption der vorliegenden Erfindung wurde allerdings festgestellt, dass die unveränderten Trainingsmesswerte eine nicht-ausreichende Datenqualität aufweisen können bzw. entsprechend bereinigt oder korrigiert werden müssen. Diese Bereinigung oder Korrektur erfolgt erfindungsgemäß im Schritt der Vorverarbeitung der aufgenommenen Daten.

Mögliche Fehler bzw. Probleme in den aufgenommenen Trainingsmesswerten können z.B. sein: ein Offset zwischen einzelnen Messreihen bzw. einzelnen Messkurven einer Messreihe, auffällig abweichende Messkurven innerhalb einer Messreihe, mit starken Schwingungen behaftete Messkurven, totale Messfehler bzw. Signalstörungen.

Nach der Vorverarbeitung der aufgenommenen Trainingsmesswerte werden ein erstes Klassifikationssystem und ein zweites Klassifikationssystem mit den vorverarbeiteten Trainingsmesswerten trainiert.

Es wäre möglich, ein einziges Klassifikationssystem zu trainieren, welches erkennt, ob ein Netzwerk fehlerfrei (OK) ist oder nicht (NOK), und bei fehlerbehafteten Netzwerken erkennt, welcher Abschnitt des Netzwerks betroffen ist. Allerdings haben entsprechende Untersuchungen gezeigt, dass die gleichzeitige OK/NOK Qualifikation mit einer Fehlerlokalisierung mit Methoden des maschinellen Lernens nur schwer durchführbar ist.

Die vorliegende Erfindung sieht daher eine zweistufige Prüfung vor. In Untersuchung zu der vorliegenden Erfindung hat sich gezeigt, dass ein defektes bzw. fehlerbehaftetes Netzwerk durch das erste Klassifikationssystem mit hoher Sicherheit erkannt werden kann. Ferner hat sich gezeigt, dass ein entsprechend trainiertes zweites Klassifikationssystem, welches nur auf das Erkennen der Fehlerstelle bzw. -position in bereits als fehlerhaft klassifizierten Netzwerken trainiert wird, diese Fehlerstelle bzw. -position ebenfalls mit sehr hoher Genauigkeit erkennen kann. Bei dieser zweistufigen Analyse bzw. Prüfung der Netzwerke können fehlerbehaftete Netzwerke folglich mit sehr hoher Genauigkeit erkannt werden und gleichzeitig der Fehler lokalisiert werden.

Erkennt also das erste Klassifikationssystem ein fehlerfreies Netzwerk, werden die entsprechenden Prüfmesswerte dem zweiten Klassifikationssystem nicht zugeführt. Klassifiziert das erste Klassifikationssystem das Netzwerk allerdings als fehlerbehaftet, werden die entsprechenden Prüfmesswerte dem zweiten Klassifikationssystem zugeführt. Da bereits bekannt ist, dass die Prüfmesswerte von einem fehlerbehafteten Netzwerk stammen, ist das zweite Klassifikationssystem darauf ausgerichtet, den Netzwerkabschnitt zu klassifizieren, welcher den Defekt aufweist.

Unter dem Begriff "Netzwerkabschnitt" können dabei Abschnitte in dem Netzwerk verstanden werden, die durch ihre Position und/oder Länge identifiziert werden. Ferner kann als "Netzwerkabschnitt" auch ein abgegrenzter Abschnitt eines Netzwerks, also z.B. eine Stichleitung an einem Bus oder ein Abschnitt der Hauptleitung des Busses zwischen zwei Stichleitungen verstanden werden. Bei einem Netzwerk mit Sternstruktur kann z.B. jeder Zweig, der von dem zentralen Knoten oder Sternkoppler abzweigt als Abschnitt betrachtet werden.

Das Verfahren gemäß der vorliegenden Erfindung kann z.B. in einer entsprechenden Prüfvorrichtung implementiert werden. Bei einer solchen Prüfvorrichtung können die erste Datenerfassungseinrichtung und die zweite Datenerfassungseinrichtung z.B. dieselbe Datenerfassungseinrichtung sein. Ebenso können die Recheneinrichtung und die Prüfsteuereinrichtung in einer einzelnen Recheneinheit bereitgestellt werden. Beispielsweise kann ein Computer bereitgestellt werden, der entsprechende Programme zur Vorverarbeitung der Trainingsmesswerte und Prüfmesswerte und zum Training der Klassifikationssysteme und zum Klassifizieren der Netzwerke ausführt. Dazu können entsprechende Programme oder Programmanweisungen in einem Speicher bereitgestellt werden und von einem Prozessor, der mit dem Speicher gekoppelt ist, geladen und ausgeführt werden. Der Computer kann z.B. auch entsprechende Messschnittstellen aufweisen bzw. mit entsprechenden Messgeräten gekoppelt sein.

Es versteht sich, dass die Prüfvorrichtung z.B. als verteiltes System bereitgestellt werden kann. Bei einem solchen verteilten System kann z.B. die Erfassung der Trainingsmesswerte und das Training der Klassifikationssysteme unabhängig von einer späteren Prüfung von Netzwerken z.B. in der Produktion von Leitungssätzen erfolgen.

In einer solchen Ausführungsform können die erste Datenerfassungseinrichtung und die Recheneinrichtung z.B. in einem Labor oder dergleichen bereitgestellt werden. Die erste Datenerfassungseinrichtung und die Recheneinrichtung können aber auch direkt an der Produktionsanlage bereitgestellt werden, z.B. nur temporär bis nach dem Training der Klassifikationssysteme. Die zweite Datenerfassungseinrichtung und die Prüfsteuereinrichtung können direkt an der Produktionsanlage bereitgestellt werden und während der Produktion der Netzwerke bzw. Leitungssätze zu deren Prüfung eingesetzt werden. Alternativ können die Recheneinrichtung und/oder die Prüfsteuereinrichtung z.B. auch auf einem zentralen Server bereitgestellt werden, der entsprechende Programme ausführt. Zur Erfassung der Trainingsmessdaten und/oder der Prüfmessdaten können dann entsprechende Messgeräte oder -Systeme bereitgestellt werden, die mit dem zentralen Server gekoppelt sein können.

Mit Hilfe der vorliegenden Erfindung wird es möglich, Fehler in komplexen elektrischen Netzwerken, insbesondere zur Hochfrequenten Datenübertragung, sehr effizient zu identifizieren. Dabei ist es nicht nur möglich, das Vorhandensein eines Fehlers zu erkennen. Vielmehr kann auch die Position des Fehlers in dem Netzwerk erkannt bzw. auf einen Netzwerkabschnitt eingegrenzt werden.

Weitere Ausführungsformen und Weiterbildungen ergeben sich aus den Unteransprüchen sowie aus der Beschreibung unter Bezugnahme auf die Figuren.

In einer Ausführungsform kann das Aufnehmen von Trainingsmesswerten das Aufnehmen von Messwerten an fehlerfreien Referenznetzwerken aufweisen. Ferner kann das Aufnehmen von Trainingsmesswerten auch das Aufnehmen von Messwerten an Referenznetzwerken aufweisen, in welchen an vorgegebenen Netzwerkabschnitten Fehler erzeugt wurden.

Für das Training der Klassifikationssysteme müssen entsprechende Trainingsdaten bereitgestellt werden. Für die Klassifikation von Netzwerken z.B. in Leitungssätzen, müssen folglich Trainingsdaten erfasst und bereitgestellt werden, welche die zu erkennenden Klassen repräsentieren.

Für das erste Klassifikationssystem müssen folglich Trainingsmesswerte in einem fehlerfreien Netzwerk aufgenommen werden, um eine OK Klassifikation (fehlerfrei) zu ermöglichen. Das erste Klassifikationssystem kann derart trainiert werden, dass es alle Netzwerke, die nicht als OK klassifiziert werden, automatisch als NOK (nicht fehlerfrei) klassifiziert. Alternativ können auch für die Klassifikation als NOK entsprechende Trainingsmesswerte aufgenommen werden, um das erste Klassifikationssystem zu trainieren.

Wie oben bereits erläutert, dient das erste Klassifikationssystem dazu, lediglich eine Unterscheidung fehlerfreier (OK) und fehlerbehafteter (NOK) Netzwerke zu ermöglichen. Das zweite Klassifikationssystem dagegen dient dazu, den Fehler in als fehlerhaft erkannten Netzwerken zu lokalisieren. Unter Lokalisieren ist dabei zu verstehen, dass das zweite Klassifikationssystem eine Indikation bzw. Klassifikation liefert, welche es erlaubt, den Abschnitt des Netzwerks zu bestimmen, in welchem der Fehler liegt.

Folglich müssen die Trainingsdaten bzw. die entsprechenden Trainingsmesswerte entsprechende Fehler repräsentieren. Weist ein Netzwerk mit einer Bustopologie (z.B. eine zentrale Leitung mit Stichleitungen zu den Busteilnehmern) beispielsweise 10 Segmente bzw. Netzwerkabschnitt auf, müssen Trainingsmesswerte für jeden Fehlerfall aufgenommen werden.

Es wird folglich in einem zweiten Schritt zur Aufnahme der Trainingsmesswerte nacheinander in jedem der Netzwerkabschnitte ein Fehler erzeugt und es werden entsprechende Trainingsmessdaten aufgenommen.

Bei einem Netzwerk mit 10 Netzwerkabschnitten werden folglich 10 Messreihen durchgeführt, jeweils eine Messreihe für jeden der Netzwerkabschnitte mit einem entsprechenden Fehler.

Wie oben bereits erläutert, wird mit der Zeitbereichsreflektometrie ein Spannungsverlauf für ein Netzwerk aufgenommen. Der Spannungsverlauf wird dabei maßgeblich durch Impedanzänderungen in dem Netzwerk geprägt. Unter einem Fehler, der in dem entsprechenden Netzwerkabschnitt erzeugt wird, kann folglich z.B. eine bewusst verursachte Impedanzänderung verstanden werden.

Es versteht sich, dass beim Aufnehmen der Trainingsmesswerte eine Vielzahl von Messungen direkt nacheinander durchgeführt werden können. Die Laufzeiten der Messsignal auf den Leitungen betragen ca. 100 cm/ns. Bei den heute üblichen Leitungslängen von mehreren Metern, kann eine Messung also im Bereich weniger Nanosekunden abgeschlossen werden.

Die entsprechende Datenerfassungseinrichtung kann folglich eine Vielzahl von Messungen in wenigen Sekunden durchführen. Dies ermöglicht es folglich sehr einfach eine große Menge an Trainingsdaten zu erzeugen, z.B. mehrere tausend Messungen für jede Messaufgabe.

In einer weiteren Ausführungsform kann zum Erzeugen der Fehler in den entsprechenden Netzwerkabschnitten die Dielektrizitätskonstante um eine entsprechende Leitung des jeweiligen Netzwerks verändert werden.

Wird die Dielektrizitätskonstante um die Leitung verändert, ändert sich an dieser Stelle auch die Impedanz der Leitung. Wie oben erläutert, führt die Impedanzänderung zu einer Reflektion, welche sich in der jeweiligen Messung niederschlägt.

Die Dielektrizitätskonstante um die Leitung kann z.B. durch das Umgreifen der Leitung mit der Hand erfolgen. Eine solche Änderung der Dielektrizitätskonstante führt zu einer Impedanzänderung der Leitung, die einer Entdrillung in der Größenordnung von einigen Millimetern entspricht. Da die Messungen sehr schnell durchgeführt werden können, stellt das Umgreifen der Leitung mit der Hand eine sehr einfache Möglichkeit dar, die Störstellen bzw. Fehler zu erzeugen und ein Netzwerk zu vermessen. Insbesondere können die Fehler sehr einfach in den unterschiedlichen Netzwerkabschnitten erzeugt werden.

Es versteht sich, dass auch eine Vorrichtung zur Aufnahme der Leitungen eines Netzwerks bzw. Leitungssatzes vorgesehen sein kann, welche gesteuert entsprechende Elemente um die Leitungen anordnen kann, welche die Dielektrizitätskonstante entsprechend ändern. Dies ermöglicht eine voll-automatisierte Erzeugung von Störstellen bzw. Fehlern in dem entsprechenden Netzwerk.

In noch einer weiteren Ausführungsform kann das Vorverarbeiten der aufgenommenen Trainingsmesswerte aufweisen, in den aufgenommenen Trainingsmesswerten Ausreißer zu erkennen und zu eliminieren. Zusätzlich oder alternativ kann das Vorverarbeiten der aufgenommenen Prüfmesswerte aufweisen, in den aufgenommenen Prüfmesswerten Ausreißer zu erkennen und zu eliminieren.

Bei der Erfassung der Trainingsmesswerte und der Prüfungsmesswerte können unterschiedliche Messfehler die Messung beeinflussen. Mögliche Fehler können z.B. sein: fehlende Werte, inkonsistente und falsche Daten, Redundanzen in Form von Datensätzen, die mehrfach vorkommen, Ausreißer, Fehlen ganzer Datensätze.

Fehlende Werte sorgen für unvollständige Daten und bilden somit nicht die gesamte Wirklichkeit im Datensatz ab. Inkonsistente und falsche Daten können z.B. sehr schnell durch Verschiebung der Dezimalstelle entstehen. Solche Werte können z.B. auch außerhalb des gültigen Wertebereichs liegen. Die Ursachen sind vielfältig: Bei der Integration von mehreren Datenquellen ineinander treten zum Beispiel ungleiche Schreibweisen, Abkürzungen und unterschiedlich verwendete Standards (Einheiten, Formate) auf. Redundanzen in Form von Datensätzen, die mehrfach vorkommen, sind deswegen problematisch, da sie die Gewichtung zugunsten des häufiger auftretenden Datensatzes verschieben und somit mehr von den Algorithmen betrachtet und zur Mustererkennung verwendet werden als die anderen. Ausreißer verfälschen das Analyseergebnis häufig signifikant. Fehlen ganze Datensätze, können auch manche eventuell wichtigen Objekte gänzlich fehlen und somit nicht für die Analysen herangezogen werden.

Es hat sich gezeigt, dass bei einer ordentlichen Planung der Datensammlung, also der Messung bzw. Erfassung der Trainingsmesswerte und der Prüfmesswerte, der Aufwand bei der Datenbereinigung deutlich reduziert werden kann. In diesem Fall sind wenige der typischen Datenfehler in den Daten vorhanden. Mit entsprechender Sorgfalt können fehlende, redundante oder falsche Daten im Vorfeld vermieden werden.

Somit sind insbesondere Ausreißer aufgrund von Messfehler und -störungen innerhalb der einzelnen Messreihen zu eliminieren.

In einer Ausführungsform kann das Erkennen von Ausreißern aufweisen, lokale Ausreißer oder globale Ausreißer zu erkennen und zu behandeln.

Ausreißer in Form von einzelnen Daten, die stark von den übrigen abweichen, gehören den zufälligen Fehlern an. Lokale Ausreißer, die im gültigen und plausiblen Wertebereich bleiben aber nicht mehr dem Trend folgen, sind oft schwer zu erkennen. Globale Ausreißer, die deutlich von den restlichen Werten abweichen, sind dagegen relativ leicht zu erkennen.

Werden in einer einzelnen Messung, also z.B. einer Spannungskurve, die mittels Zeitbereichsreflektometrie erfasst wurde, ein Ausreißer entdeckt, muss dieser entsprechend behandelt werden.

Sind Datenfehler, also Ausreißer, als solche erkannt worden, können sie auf unterschiedliche Weise behandelt werden. Mögliche Korrekturen bzw. Behandlungen beinhalten:
- Fehler im Datensatz beibehalten, diese aber deutlich kennzeichnen, damit sie bei der weiteren Verwendung entsprechend berücksichtigt werden können
- Ungültige Daten durch definierte Fehlerwerte ersetzen, die im Nachhinein auch als solche erkannt werden
- Korrektur bei falschem Wert und Schätzung bei fehlendem Wert für einzelne Objekte. Dabei gibt es diverse Möglichkeiten:
   - Statistische Kennzahlen wie arithmetischer Mittelwert, Median, Minimum oder Maximum
   - Übernahme des Werts des nächsten Nachbars, der mittels Ähnlichkeitsmaßen bestimmt werden kann
   - Lineare Interpolation bei Zeitreihen, wenn einzelne Werte innerhalb der Reihe fehlen, auch nichtlineare Interpolationen bei Anwendung auf Splines
   - Modellbasierte Schätzung durch Regression oder andere Vorhersagetypen im Bereich des Machine Learnings
   - Filterung der Signale, wodurch Ausreißer und viele Datenfehler automatisch erkannt und gleichzeitig entfernt werden
   - Entfernen von ganzen Features oder ganzer Datensätze bei mind. 1 fehlerhaftem Merkmal

Bei der vorliegenden Erfindung können - wie oben erläutert - sehr einfach eine Vielzahl von Messreihen (oben auch als Features oder Datensatz bezeichnet) erzeugt werden. Folglich stehen im Regelfall genügend Daten zur Verfügung, um fehlerhafte Datensätze zu entfernen. Dadurch wird insbesondere auch verhindert, dass die in den Messreihen enthaltene Information verändert wird.

In noch einer Ausführungsform kann das Erkennen von Ausreißern mittels der 2-Sigma-Regel oder mittels Ausreißertest nach Grubbs und Hampel oder mittels "Local Outlier Factor" Algorithmus durchgeführt werden.

Bei der 2-Sigma-Regel, werden Ausreißer als solche deklariert, wenn sie mindestens zwei Standardabweichungen vom Mittelwert der Verteilung entfernt liegen. Zur Erniedrigung der Irrtumswahrscheinlichkeit kann der Abstand auch auf drei Standardabweichungen erhöht werden. Zur Anwendung der 2-Sigma-Regel ist eine Normalverteilung der Daten wichtig. Dies kann im Vorfeld durch einen geeigneten Test sichergestellt werden.

Der Ausreißertest nach Grubbs stellt ein iteratives Verfahren dar, bei welchen nacheinander immer der Ausreißer mit dem höchsten Abstand zum Arithmetischen Mittel detektiert wird, bis keine Ausreißer mehr auftreten. Der Ausreißertest nach Hampel optimierte den Test nach Grubbs, indem anstelle des arithmetischen Mittelwerts der Median m und anstelle der Standardabweichung der Median der absoluten Abweichungen vom Median - MAD (Median Absolute Deviation) - verwendet wird. Damit wird die Ausreißer-Detektion unabhängig von der Schätzung des Mittelwerts und der Standardabweichung, auf welche die Ausreißer enorme Effekte haben und diese somit verzerren.

In einer weiteren Ausführungsform kann das Vorverarbeiten der aufgenommenen Trainingsmesswerte aufweisen, in den aufgenommenen Trainingsmesswerten Offsetfehler zu erkennen und zu eliminieren. Zusätzlich oder alternativ kann das Vorverarbeiten der aufgenommenen Prüfmesswerte aufweisen, in den aufgenommenen Prüfmesswerten Offsetfehler zu erkennen und zu eliminieren.

Systematischen Abweichungen zwischen den Messreihen in Form von Offsets sind eine weitere Fehlerart, die durch eine gewissenhafte Vorbereitung der Messung nicht immer eliminiert werden können. Offsetfehler zuverlässig zu identifizieren und mit geeigneten Methoden der Datenbereinigung zu eliminieren kann daher das Training der Klassifikationssysteme deutlich erleichtern bzw. die Klassifikationsergebnisse verbessern.

In einer weiteren Ausführungsform kann das Erkennen und Eliminieren von Offsetfehlern aufweisen, die aufgenommen Trainingsmesswerte in differentielle Messwerte zu wandeln. Zusätzlich oder alternativ kann das Erkennen und Eliminieren von Offsetfehlern aufweisen, die aufgenommen Prüfmesswerte in differentielle Messwerte zu wandeln.

Unter dem Begriff eines differentiellen Messwerts ist zu verstehen, dass der Wert eines Messwerts in einer Messreihe jeweils den Abstand zu dem vorhergehenden Wert kennzeichnet. Der erste Werte einer jeden Messreihe kann dabei z.B. mit einem vorgegebenen Wert, insbesondere 0, angenommen werden.

Zur Veranschaulichung sei lediglich beispielhaft die Messreihe mit den Absolutwerten 3, 6, 7, 9, 3 in eine differentielle Messreihe umgewandelt. Das Ergebnis der Umwandlung ist dann 0, 3, 1, 2, -6.

Die Darstellung der Messwerte als differentielle Messwerte bzw. differentielle Messreihen eliminiert den Offset automatisch und ist sehr einfach durchzuführen.

In einer Ausführung kann lediglich ein Bereich der Messreihen ausgeschnitten und einer Erkennung und Eliminierung des Offsets unterzogen werden. Insbesondere kann dieser Bereich z.B. beginnend mit der Einspeisung des Messsignals, also z.B. einer Spannungsstufe, ausgewählt werden. Auf diese Weise wird vermieden, dass vor Beginn der eigentlichen Messung Messwerte mit 0 V als Teil der Messung angesehen werden. Für den weiteren Verlauf der Prüfung können dann jeweils diese Bereiche genutzt werden.

In einer Ausführungsform kann das Vorverarbeiten der aufgenommenen Trainingsmesswerte aufweisen, jeweils eine Mehrzahl, insbesondere 2, 4, 8, 16, 32 oder 64, einzelner Messkurven zu aggregieren. Zusätzlich oder alternativ kann das Vorverarbeiten der aufgenommenen Prüfmesswerte aufweisen, jeweils eine Mehrzahl, insbesondere 2, 4, 8, 16, 32 oder 64, einzelner Messkurven zu aggregieren.

Das Vorverarbeiten der aufgenommenen Trainingsmesswerte und das Vorverarbeiten der aufgenommenen Prüfmesswerte kann auch ein sogenanntes "Feature Engineering" aufweisen. Feature Engineering beschreibt einen Prozess, um Merkmale zu generieren, die es einem Algorithmus des maschinellen Lernens ermöglichen, gute Vorhersagen zu treffen. Dazu werden erfindungsgemäß bestehende Merkmale, also z.B. Messwerte, kombiniert bzw. transformiert, damit neue hilfreiche Informationen entstehen.

Eine grundlegende Form des Feature Engineering ist z.B. die Datenreduktion, bei der ein sehr umfangreicher Datensatz reduziert wird. Eine zweite Form des Feature Engineering ist die Datentransformation.

Mögliche konkrete Ausführungen können z.B. eine Normalisierung und Skalierung aufweisen. Ferner können für Prüfmesswerte z.B. deren Differenzen zu einer Referenzmesskurve angegeben werden. Die Referenzmesskurve kann z.B. als Mittelung aller Trainingsmesswerte im fehlerfreien Fall bereitgestellt werden. Ferner kann auf die Messwerte eine Fourier-Transformation, z.B. eine Fast-Fourier-Transformation angewendet werden. Eine weitere Möglichkeit ist, ein Binning auf der Zeitachse anzuwenden, wobei dabei n aufeinanderfolgende Datenpunkte durch ihren Mittelwert ersetzt werden.

Wie oben erläutert kann, auch eine Aggregation von Messkurven durchgeführt werden. Für die Aufgabe der Prüfung von Netzwerken hat sich die Aggregation von Messkurven als besonders vorteilhaft erwiesen. Um Messkurven zu aggregieren, wird für die einzelnen Messpunkte bzw. Messwerte der Messkurven jeweils der arithmetische Mittelwert gebildet.

Dabei kann jeweils eine unterschiedliche Anzahl von Messkurven aggregiert werden. Insbesondere können z.B. 16 Messkurven aggregiert werden, was sich als besonders vorteilhaft für die Fehlerrate der Klassifikationssysteme herausgestellt hat.

In einer weiteren Ausführungsform kann das erste Klassifikationssystem auf einem Entscheidungsbaum-Algorithmus oder einem Algorithmus nach der Ensemble-Methode, insbesondere einem AdaBoost-Algorithmus, oder einem Algorithmus zur Logistischen Regression oder einem Naive-Bayes-Klassifikator Algorithmus oder einem K-Nächste-Nachbarn-Klassifikator Algorithmus oder einem Supportvektormaschinen-Algorithmus basieren. Zusätzlich oder alternativ kann das zweite Klassifikationssystem auf einem Entscheidungsbaum-Algorithmus oder einem Algorithmus nach der Ensemble-Methode, insbesondere einem AdaBoost-Algorithmus, oder einem Algorithmus zur Logistischen Regression oder einem Naive-Bayes-Klassifikator Algorithmus oder einem K-Nächste-Nachbarn-Klassifikator Algorithmus oder einem Supportvektormaschinen-Algorithmus basieren.

Ein Entscheidungsbaum funktioniert anders als andere Klassifikatoren, da nicht alle Features bzw. Merkmale gleichzeitig bei der Vorhersage der Klasse, aber auch bei der Modellbildung, herangezogen werden. Es wird sukzessive entschieden, welches nächste Merkmal am besten geeignet ist, die Daten zu separieren. So entsteht eine Hierarchie von Regeln für einzelne Features, die in Form eines Baums visualisiert werden kann.

Der Entscheidungsbaum kann Modelle hoher Komplexität darstellen, die Interpretierbarkeit bleibt durch den hierarchischen Aufbau sehr übersichtlich. Mithilfe von Ensemble-Methoden kann die Leistungsfähigkeit durch Kombination vieler verschiedener Entscheidungsbäume zu einer Vorhersageeinheit gesteigert werden, wodurch Fehlentscheidungen einzelner Klassifikatoren durch andere ausgeglichen werden. Dadurch erhöht sich die möglich abzubildende Komplexität, die Nachvollziehbarkeit geht dadurch verloren. Zwei mögliche Ensemble-Methoden sind der Random Forest und der Adaboost Algorithmus.

Der K-Nächste-Nachbarn-Klassifikator beschreibt ein relativ einfaches Klassifikationsverfahren, welches auf Ähnlichkeiten beruht. Es werden mithilfe eines geeigneten Abstandsmaßes eine definierten Anzahl k an nächsten Nachbarn bestimmt. Alle die somit ermittelten Nachbarn sind einer bestimmten Klasse zugewiesen. Diejenige Klasse, die in dieser Auswahl vorherrscht, wird selektiert und dem neu einzuordnenden Objekt zugewiesen.

Der Entscheidungsbaum und der K-Nächste-Nachbarn Klassifikator werden nach entsprechenden Untersuchungen als die erfolgversprechendsten Algorithmen zur Klassifikation von Netzwerken in Leitungssätzen angesehen.

Allerdings können die weiteren genannten Algorithmen ebenfalls eingesetzt werden.

Die logistische Regression ermittelt die Klasse, zu der ein Objekt am wahrscheinlichsten gehört. Der Name impliziert bereits, dass ein Wert ermittelt wird, in diesem Fall die Wahrscheinlichkeit, dass eine Beobachtung einer bestimmten Klasse angehörig ist. Die höchste Wahrscheinlichkeit bestimmt anschließend die Zuweisung.

Die Supportvektormaschine ist gewissermaßen mit der logistischen Regression verwandt und versucht durch eine Hyperebene die Daten unterschiedlicher Klassen zu separieren. Diese kann als Grenze verwendet werden, um neue Objekte entsprechend einzuordnen.

Der Naiver-Bayes-Klassifikator ist ein probabilistisches Klassifikationsverfahren, welches auf den Satz von Bayes beruht. Naiv ist der Klassifikator deswegen, weil er annimmt, dass alle Variablen voneinander stochastisch unabhängig sind. Das heißt, die Werte der einzelnen Features haben keinen direkten Einfluss aufeinander.

In einer weiteren Ausführungsform kann für das erste Klassifikationssystem eine Parameteroptimierung durchgeführt werden. Zusätzlich oder alternativ kann auch für das zweite Klassifikationssystem eine Parameteroptimierung durchgeführt werden.

Alle der oben genannten Algorithmen weisen unterschiedliche Parameter auf, die für jede Klassifikationsaufgabe entsprechend angepasst werden können, um die Klassifikationsergebnisse zu optimieren. Das Anpassen dieser Parameter wird hier auch als Parameteroptimierung bezeichnet.

Zwei Möglichkeiten zur Parameteroptimierung sind der sog. Grid Search Ansatz und der sog. Random Search Ansatz.

Bei Grid Search wird ein Bereich für die zu untersuchenden Parameter festgelegt. Anschließend wird die komplette mögliche Kombinatorik daraufhin untersucht, welche Kombination die Beste zur Lösung des Problems ist. Grid Search eignet sich insbesondere dann, wenn wenige Parameter mit wenigen Ausprägungen zu optimieren sind und genügend Rechenzeit dazu zur Verfügung steht.

Random Search bietet die Möglichkeit, zufällige Kombinationen von Parameterbelegungen, die sich in einem festgelegten Bereich befinden, zu bewerten. Dies eignet sich vor allem dann, wenn es sehr viele unterschiedliche Parameterdimensionen gibt und somit ein Grid Search aufgrund der benötigten Rechenzeit nicht möglich ist.

Beispielhaft sei hier die Parameteroptimierung für einen Entscheidungsbaum zur OK/NOK Prüfung von Netzwerken erläutert:
Beim Entscheidungsbaum gilt es folgende Parameter zu optimieren:
1. 'criterion' für die Angabe des Kriteriums, welches die Qualität der Splits bewertet und auf Basis dessen die Entscheidung getroffen wird, welche der Splits am besten geeignet ist. Implementiert sind der Gini-Index und die Entropie. Beide sollen getestet werden.
2. 'min_samples_leaf' gibt an, wie viele Objekte sich jeweils mindestens in einem Blatt (Klassenentscheidung) befinden müssen, damit der Split zulässig ist. Dies stellt ein Abbruchkriterium für das Pruning des Entscheidungsbaums dar.

In einem Beispiel eines voll ausgebildeten Entscheidungsbaums können Endknoten existieren, die teilweise nur ein einziges Objekt enthalten. Somit kann ein Übertrainieren vermutet werden. Aus diesem Grund kann bei der Parameteroptimierung der eben erwähnte Parameter 'min_samples_leaf' in einem Bereich von eins bis 20 getestet werden. Da es sich bei Betrachtung der beiden Parameter um wenige Kombinationen handelt, soll das Konzept des Grid Search angewandt werden.

Beim Zweiklassenmodell, also dem ersten Klassifikationssystem zur OK/NOK Klassifikation, kann das Vorhersagemodell z.B. am zuverlässigsten bzgl. der Metrik des FScores (ß=3) arbeiten, wenn die Qualität der Splits mit dem Gini-Index berechnet wird und das Pruning im geringen Maße ausgeprägt ist. Im geringen Maße heißt, dass sich nach der Parameteroptimierung mindestens zwei Objekte in einem Blatt des Entscheidungsbaums befinden müssen, der Parameter 'min_samples_leaf' also den Wert 2 hat.

Beim Multiklassenvorhersagemodell, also dem zweiten Klassifikationssystem zur Fehlerlokalisation, zeigt sich, dass Pruning keinen positiven Einfluss hat, aber anstelle des Gini-Index die Entropie verwendet werden sollte. Ferner sind die Unterschiede bei der Parameteroptimierung nicht sehr groß sind und das Übertrainieren spielt keine große Rolle. Es hat sich gezeigt, dass die Vorhersage umso schlechter wird, je mehr das Pruning ausgeprägt ist. Das Pruning kann nach der Parameteroptimierung also minimiert werden.

Ferner sei beispielhaft die Parameteroptimierung für den K-Nächsten-Nachbar-Klassifikator aufgezeigt:
Beim K-Nächsten-Nachbar-Klassifikator sind folgende Parameter zu optimieren:
1. 'n_neighbors': Gibt die Anzahl der nächsten Nachbarn an, die zur Klassifikation des Objekts herangezogen werden. Es können z.B. alle ungeraden Werte zwischen 3 und 15 getestet werden.
2. 'p': Angabe der Potenz für die Minkowski-Metrik. p = 1 entspricht hierbei der Manhatten-Distanz, p=2 der euklidischen Distanz. Es können z.B. alle Werte von eins bis drei getestet werden.
3. 'weights': Gewichtsfunktion, die angibt, wie die Nachbarn für die Entscheidungsfindung gewichtet werden. Entweder werden alle gleich gewichtet (Ausprägung 'uniform') oder das Gewicht durch den Kehrwert der Distanz berechnet (Ausprägung 'distance'), sodass näherliegende Nachbarn einen größeren Einfluss auf das Ergebnis haben. Beide Möglichkeiten können im Rahmen der Parameteroptimierung erprobt werden.

Auf Grund der überschaubaren Anzahl der möglichen Kombinationen kann auch hier Grid Search angewandt werden. Das Ergebnis kann z.B. für das Zweiklassenvorhersagemodell zeigen, dass die Anzahl der zu betrachtenden Nachbarn nicht zu hoch gewählt werden sollte, da die Vorhersagegenauigkeit sinken kann. Beispielsweise kann dieser Parameter auf einen Wert kleiner 11 gesetzt werden.

Wird dabei die Gewichtung der zur Vorhersage ermittelten Nachbarn von der Distanz abhängig gemacht, kann der eben beschriebene Effekt verschwinden und die Vorhersagegenauigkeit bleibt bis zum maximalen Wert von 15 für die Anzahl der zu betrachtenden Nachbarn gleich. Auch die Art und Weise, nach welcher Metrik die Distanz berechnet wird, hat eventuell keinen Einfluss.

Aus diesem Grund kann der K-Nächsten-Nachbar-Klassifikator mit fünf zu betrachtenden Nachbarn und der euklidische Abstand als Distanzmaß genutzt werden. Lediglich die Gewichtung der Nachbarn kann abhängig von der Distanz gemacht werden. Dies kann die Robustheit der Vorhersage erhöhen.

Die hier genannten Parameterwerte können sowohl für das erste Klassifikationssystem als auch das zweite Klassifikationssystem genutzt werden.

In einer weiteren Ausführungsform kann beim Trainieren des ersten Klassifikationssystems ein vorgegebener Anteil, insbesondere zwischen 70% und 95%, der vorverarbeiteten Trainingsmesswerte für das Training des ersten Klassifikationssystems genutzt werden und der verbleidende Anteil der vorverarbeiteten Trainingsmesswerte für eine Verifikation des Trainings genutzt werden. Zusätzlich oder alternativ kann beim Trainieren des zweiten Klassifikationssystems ein vorgegebener Anteil, insbesondere zwischen 70% und 95%, der vorverarbeiteten Trainingsmesswerte für das Training des ersten Klassifikationssystems genutzt werden und der verbleidende Anteil der vorverarbeiteten Trainingsmesswerte für eine Verifikation des Trainings genutzt werden.

Durch die Aufteilung der Trainingsmesswerte kann sichergestellt werden, dass eine ausreichend hohe Menge an Messwerten für die Überprüfung der Klassifikationssysteme zur Verfügung steht.

Wie bereits dargestellt ist auch von Vorteil ein Programm, Computerprogrammprodukt oder Computerprogramm mit Programmcode, der auf einem maschinenlesbaren Träger oder Speichermedium wie einem Halbleiterspeicher, einem Festplattenspeicher oder einem optischen Speicher gespeichert sein kann und zur Durchführung, Umsetzung und/oder Ansteuerung der Schritte des Verfahrens nach einer der vorstehend beschriebenen Ausführungsformen verwendet wird, insbesondere wenn das Computerprogrammprodukt oder Programm auf einem Computer oder einer Vorrichtung ausgeführt wird. Unter einem Programm kann ein Computerprogrammprodukt verstanden werden. Unter Programmcode können auch Programmanweisungen verstanden werden.

### Kurze Figurenbeschreibung

Nachfolgend werden vorteilhafte Ausführungsbeispiele der Erfindung unter Bezugnahme auf die begleitenden Figuren erläutert. Es zeigen:
- Figur 1: ein Ablaufdiagram eines Ausführungsbeispiels eines Verfahrens gemäß der vorliegenden Erfindung;
- Figur 2: ein Ablaufdiagram eines weiteren Ausführungsbeispiels eines Verfahrens gemäß der vorliegenden Erfindung,
- Figur 3: ein Blockschaltbild eines Ausführungsbeispiels einer Prüfvorrichtung gemäß der vorliegenden Erfindung;
- Figur 4: ein Blockschaltbild eines weiteren Ausführungsbeispiels einer Prüfvorrichtung gemäß der vorliegenden Erfindung;
- Figur 5: ein Beispiel eines möglichen Netzwerks zur Verwendung mit der vorliegenden Erfindung;
- Figur 6: ein Beispiel eines weiteren möglichen Netzwerks zur Verwendung mit der vorliegenden Erfindung; und
- Figur 7: ein Diagramm einer Messung an einem elektrischen Netzwerk.

Die Figuren sind lediglich schematische Darstellungen und dienen nur der Erläuterung der Erfindung. Gleiche oder gleichwirkende Elemente sind durchgängig mit den gleichen Bezugszeichen versehen.

### Detaillierte Beschreibung

Zum leichteren Verständnis werden in der folgenden Beschreibung der verfahrensbezogenen Figuren die Bezugszeichen zu den vorrichtungsbezogenen Figuren als Referenz beibehalten.

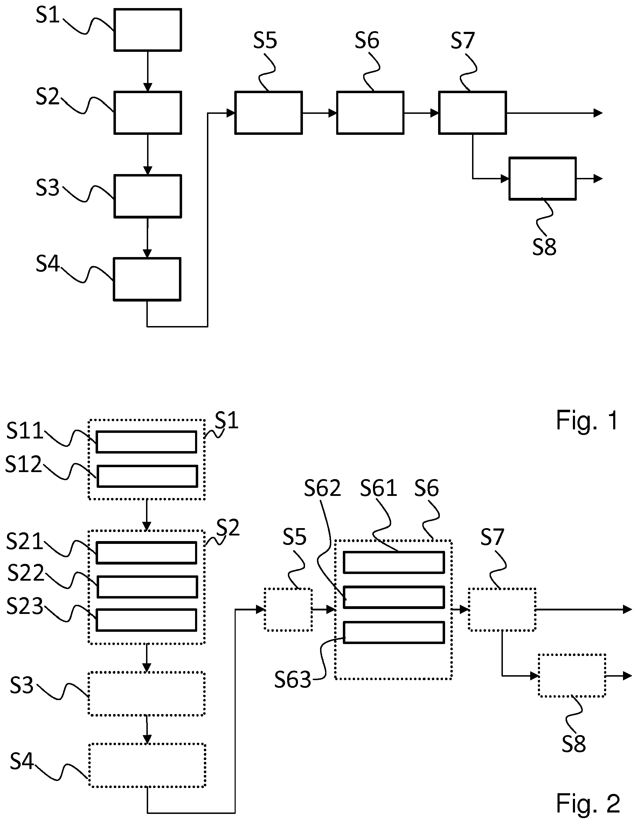

Figur 1 zeigt ein Ablaufdiagram eines Verfahrens zum Prüfen eines Netzwerks 151, 360, 461 mit einer Anzahl von Netzwerkabschnitten A - I, J - Q. Ein solches Netzwerk 151, 360, 461 kann z.B. Bestandteil eines Leitungssatzes für ein Fahrzeug mit einer Vielzahl solcher Netzwerke 151, 360, 461 sein.

In einem ersten Schritt S1 des Aufnehmens werden Trainingsmesswerte 102 für eine Anzahl von Referenznetzwerken 150 aufgenommen. Dabei entsprechen die Referenznetzwerke 150 dem zu prüfenden Netzwerk 151, 360, 461. Es versteht sich, dass die Trainingsmesswerte 102 alle an einem Referenznetzwerk 150 oder an unterschiedlichen Referenznetzwerken 150 erfasst werden können.

In einem zweiten Schritt S2 des Vorverarbeitens, werden die aufgenommenen Trainingsmesswerte 102 zum Eliminieren von Datenfehlern in den Trainingsmesswerten 102 vorverarbeitet.

In einem dritten Schritt S3 des Trainierens, wird ein erstes Klassifikationssystem 104, 204 mit den Trainingsmesswerten 102 trainiert, wobei das erste Klassifikationssystem 104, 204 auf mindestens einem Algorithmus aus dem Bereich des maschinellen Lernens basiert und ausgebildet ist, ein Netzwerk 151, 360, 461 entweder als fehlerfrei oder fehlerbehaftet zu klassifizieren.

In einem vierten Schritt S4 des Trainierens, wird ein zweites Klassifikationssystem 105, 205 mit den Trainingsmesswerten 102 trainiert, wobei das zweite Klassifikationssystem 105, 205 auf mindestens einem Algorithmus aus dem Bereich des maschinellen Lernens basiert und ausgebildet ist, einen fehlerbehafteten Netzwerkabschnitt A - I, J - Q eines Netzwerks 151, 360, 461 zu klassifizieren.

In einem fünften Schritt S5 des Aufnehmens, werden Prüfmesswerte 107 für das bzw. an oder in dem zu prüfenden Netzwerk 151, 360, 461 aufgenommen.

In einem sechsten Schritt S6 des Vorverarbeitens, werden die aufgenommenen Prüfmesswerte 107 zum Eliminieren von Datenfehlern in den Trainingsmesswerten 102 vorverarbeitet.

In einem siebten Schritt S7 des Klassifizierens, wird das zu prüfenden Netzwerk 151, 360, 461 anhand der aufgenommenen Prüfmesswerte 107 mit dem trainierten ersten Klassifikationssystem 104, 204 als fehlerfrei oder fehlerbehaftet klassifiziert. Schließlich wird in einem achten Schritt S8 des Klassifizierens der fehlerbehaftete Netzwerkabschnitt A - I, J - Q des zu prüfenden Netzwerks 151, 360, 461 mit dem trainierten zweiten Klassifikationssystem 105, 205 klassifiziert, wenn das zu prüfende Netzwerk 151, 360, 461 von dem trainierten ersten Klassifikationssystem 104, 204 als fehlerbehaftet klassifiziert wurde.

Das Klassifikationsergebnis wird also erfindungsgemäß zweistufig erzeugt. Mit dem ersten Klassifikationssystem 104, 204 wird in dem Schritt 7 geprüft, ob das zu prüfende Netzwerk 151, 360, 461 fehlerfrei, OK, ist oder nicht, NOK. Lediglich für Netzwerke 151, 360, 461, die nicht fehlerfrei, NOK, sind, wird dann mittels des zweiten Klassifikationssystem 105, 205 ermittelt, in welchem Netzwerkabschnitt sich der Fehler befindet. Es versteht sich, dass diese zweite Klassifikation für Netzwerke 151, 360, 461 mit nur einem Netzwerkabschnitt übersprungen bzw. unterlassen werden kann.

Es versteht sich, dass das erste Klassifikationssystem 104, 204 und/oder das zweite Klassifikationssystem 105, 205 z.B. auf einem Entscheidungsbaum-Algorithmus oder einem Algorithmus nach der Ensemble-Methode, insbesondere einem AdaBoost-Algorithmus, oder einem Algorithmus zur Logistischen Regression oder einem Naive-Bayes-Klassifikator Algorithmus oder einem K-Nächste-Nachbarn-Klassifikator Algorithmus oder einem Supportvektormaschinen-Algorithmus basieren können. Weitere Algorithmen aus dem Bereich des maschinellen Lernens, wie z.B. neuronale Netze oder dergleichen sind ebenfalls möglich.

Figur 2 zeigt ein Ablaufdiagram eines weiteren Verfahrens zum Prüfen eines Netzwerks 151, 360, 461 mit einer Anzahl von Netzwerkabschnitten A - I, J - Q. Das Verfahren der Figur 2 basiert auf dem Verfahren der Figur 1. Bei dem Verfahren der Figur 2 sind aber insbesondere die oben erläuterten Schritte S1, S2 und S6 detaillierter ausgeführt.

Im Schritt S1 können in dem Unterschritt S11 des Aufnehmens Trainingsmesswerte 102 an einem oder mehreren fehlerfreien Referenznetzwerken 150 aufgenommen werden. Fehlerfrei bedeutet, dass für die Referenznetzwerke 150 sichergestellt wird, dass diese keinen die Messung beeinflussenden Fehler aufweisen. Dies kann z.B. durch vorherige Prüfungen an den Referenznetzwerken 150 sichergestellt werden. Es versteht sich, dass die Messungen zur einmaligen Überprüfung eines Referenznetzwerks 150 aufwändiger sein können, als die späteren Messungen an den zu prüfenden Netzwerken 151, 360, 461 z.B. in der Serienproduktion von Leitungssätzen.

Um für das Training des ersten Klassifikationssystems 104, 204 bzw. des zweiten Klassifikationssystems 105, 205 auch Trainingsdaten für den Fehlerfall bzw. für Fehler in einzelnen Netzwerkabschnitten der zu prüfenden Netzwerke 151, 360, 461 bereitstellen zu können, kann ein weiterer Unterschritt vorgesehen sein. In dem Unterschritt S12 des Aufnehmens können Messwerte an Referenznetzwerken 150 aufgenommen bzw. gemessen werden, in welchen an vorgegebenen Netzwerkabschnitten A - I, J - Q Fehler erzeugt wurden. Insbesondere können dabei nacheinander an allen Netzwerkabschnitten Fehler erzeugt werden und jeweils entsprechende Messungen und Aufnahmen durchgeführt werden. Zum Erzeugen der Fehler in den entsprechenden Netzwerkabschnitten A - I, J - Q kann z.B. jeweils die Dielektrizitätskonstante um eine entsprechende Leitung des jeweiligen Netzwerks 151, 360, 461 verändert werden.

Im Schritt S2 des Vorverarbeitens können in einem Unterschritt S21 des Eliminierens in den aufgenommenen Trainingsmesswerten 102 Ausreißer erkannt und eliminiert werden. Das Erkennen von Ausreißern kann aufweisen, lokale Ausreißer oder globale Ausreißer zu erkennen und diese entsprechend zu behandeln. Das Erkennen von Ausreißern kann z.B. mittels der 2-Sigma-Regel oder mittels Ausreißertest nach Grubbs und Hampel oder mittels Local Outlier Factor Algorithmus durchgeführt werden.

Im Schritt S2 des Vorverarbeitens können ferner in dem Unterschritt S22 des Erkennens und Eliminierens in den aufgenommenen Trainingsmesswerten 102 Offsetfehler erkannt und eliminiert werden. Zum Erkennen und Eliminieren von Offsetfehlern können die aufgenommen Trainingsmesswerte 102 z.B. in differentielle Messwerte gewandelt werden. Schließlich kann der Schritt S2 des Vorverarbeitens den Unterschritt S23 des Aggregierens aufweisen. In dem Unterschritt S23 kann jeweils eine Mehrzahl, insbesondere 2, 4, 8, 16, 32 oder 64, einzelner Messkurven aggregiert werden.

Der Schritt S6 des Vorverarbeitens weist in dem Unterschritt S61 des Erkennens und Eliminierens auf, in den aufgenommenen Prüfmesswerten 107 Ausreißer zu erkennen und zu eliminieren. Das Erkennen von Ausreißern kann aufweisen, lokale Ausreißer oder globale Ausreißer zu erkennen und zu behandeln. Dazu können z.B. Algorithmen nach der 2-Sigma-Regel oder der Ausreißertest nach Grubbs und Hampel oder der Local Outlier Factor Algorithmus genutzt werden.

Der Schritt S6 des Vorverarbeitens kann ferner den Unterschritt S62 aufweisen, bei welchem in den aufgenommenen Prüfmesswerten 107 Offsetfehler erkannt und eliminiert werden. Zum Erkennen und Eliminieren von Offsetfehlern können die aufgenommen Prüfmesswerte 107 z.B. in differentielle Messwerte gewandelt werden. Es versteht sich, dass dabei eine explizite Erkennung nicht durchgeführt werden muss und durch die Wandlung in differentielle Messwerte die Offsetkorrektur automatisch erfolgt.

Der Schritt S6 des Vorverarbeitens kann schließlich den Unterschritt S63 des Aggregierens aufweisen. In diesem Schritt S63 kann jeweils eine Mehrzahl, insbesondere 2, 4, 8, 16, 32 oder 64, einzelner Messkurven aggregiert werden.

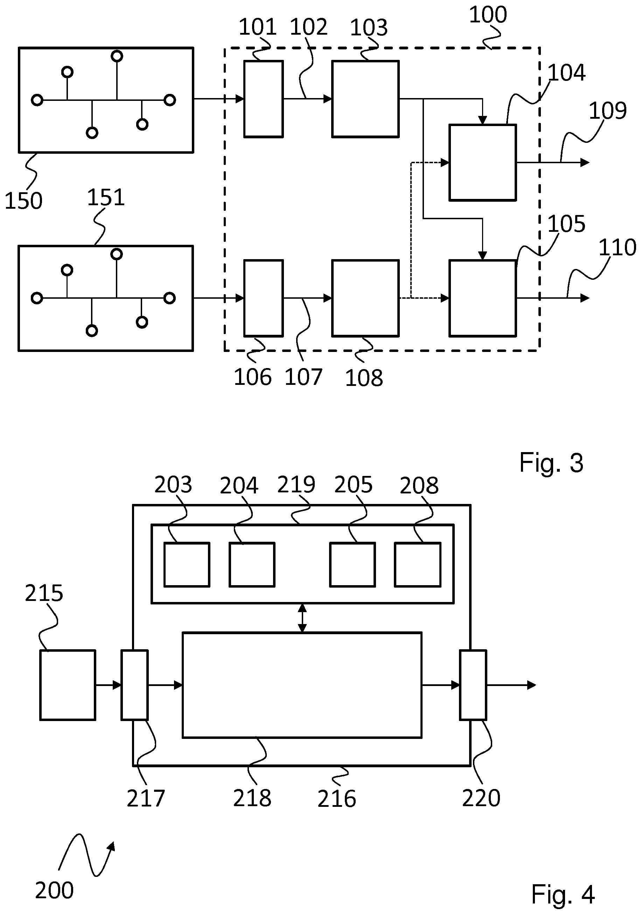

Figur 3 zeigt ein Blockschaltbild einer Prüfvorrichtung 100 zur Prüfung eines Netzwerks 151 mit einer Anzahl von Netzwerkabschnitten. Ein solches Netzwerk 151 kann z.B. Teil eines Leitungssatzes mit einer Anzahl solcher Netzwerke 151 sein.

Die Prüfvorrichtung 100 weist eine erste Datenerfassungseinrichtung 101 auf, die mit einer Recheneinrichtung 103 gekoppelt ist. Die Recheneinrichtung 103 ist mit einem ersten Klassifikationssystem 104 und einem zweiten Klassifikationssystem 105 gekoppelt. Ferner weist die Prüfvorrichtung 100 eine zweite Datenerfassungseinrichtung 106 auf, welche mit einer Prüfsteuereinrichtung 108 gekoppelt ist. Die Prüfsteuereinrichtung 108 ist ebenfalls mit dem ersten Klassifikationssystem 104 und mit dem zweiten Klassifikationssystem 105 gekoppelt.

Die erste Datenerfassungseinrichtung 101 erfasst im Betrieb Trainingsmesswerte 102 für eine Anzahl von Referenznetzwerken 150. Die Referenznetzwerke 150 entsprechen dabei dem zu prüfenden Netzwerk 151. Die Recheneinrichtung 103 verarbeitet die aufgenommenen Trainingsmesswerte 102 und eliminiert aus diesen Datenfehler, welche im weiteren Verlauf negativen Einfluss auf die Erkennungsqualität der Fehlererkennung in Netzwerk 151 hätten.

Das erste Klassifikationssystem 104 basiert auf mindestens einem Algorithmus aus dem Bereich des maschinellen Lernens und ist ausgebildet, ein Netzwerk 151 entweder als fehlerfrei oder fehlerbehaftet zu klassifizieren. Das zweite Klassifikationssystem 105 basiert auf mindestens einem Algorithmus aus dem Bereich des maschinellen Lernens und ist ausgebildet, einen fehlerbehafteten Netzwerkabschnitt eines Netzwerks 151 zu klassifizieren. Die Recheneinrichtung 103 nutzt die erfassten Trainingsmesswerte 102 um das erste Klassifikationssystem 104 mit diesen zu trainieren, und um das zweite Klassifikationssystem 105 mit diesen zu trainieren.

Nach dem Training ist das erste Klassifikationssystem 104 folglich trainiert, Netzwerke 151 anhand von Messdaten in fehlerfreie, OK, und nicht fehlerfreie, NOK, Netzwerke einzuteilen. Das zweite Klassifikationssystem 105 dagegen ist nach dem Training in der Lage, in fehlerhaften Netzwerken den entsprechenden Netzwerkabschnitt zu identifizieren, welcher den Fehler aufweist.

Die zweite Datenerfassungseinrichtung 106 erfasst Prüfmesswerte 107 für das bzw. in oder an dem zu prüfenden Netzwerk 151 und übermittelt diese an die Prüfsteuereinrichtung 108. Die Prüfsteuereinrichtung 108 führt mit den aufgenommenen Prüfmesswerten 107 ebenfalls eine Vorverarbeitung zum Eliminieren von Datenfehlern in den Trainingsmesswerten 102 durch.

Ferner klassifiziert die Prüfsteuereinrichtung 108 das zu prüfende Netzwerk 151 anhand der aufgenommenen Prüfmesswerte 107 mit dem trainierten ersten Klassifikationssystem 104 als fehlerfrei oder fehlerbehaftet. Das Klassifikationsergebnis 109 kann z.B. zur Dokumentation bzw. Information an einen Benutzer ausgegeben werden. Ist ein Netzwerk 151 als fehlerbehaftet identifiziert worden, klassifiziert die Prüfsteuereinrichtung 108 den fehlerbehafteten Netzwerkabschnitt des zu prüfenden Netzwerks 151 mit dem trainierten zweiten Klassifikationssystem 105.

Figur 4 zeigt ein Blockschaltbild einer weiteren Prüfvorrichtung 200. Die Prüfvorrichtung 200 basiert auf der Prüfvorrichtung 100. Folglich weist die Prüfvorrichtung 200 eine Datenerfassungseinrichtung 215 auf, die über eine Datenschnittstelle 217 einer Steuervorrichtung 216 mit einer Recheneinheit 218 gekoppelt ist. Die Recheneinheit 218 kann z.B. als ein Prozessor eines Computers ausgebildet sein und ist mit einem Speicher 219 gekoppelt. In dem Speicher sind die Programmanweisungen bzw. Befehle 203, 204, 205, 208 gespeichert, welche Programme bilden, welche die Funktion der Recheneinrichtung 103, des ersten Klassifikationssystems 104, des zweiten Klassifikationssystem 105 und der Prüfsteuereinrichtung 208 abbilden. Bei der Prüfvorrichtung 200 sind die Recheneinrichtung 203, das erste Klassifikationssystem 204, das zweite Klassifikationssystem 205 und die Prüfsteuereinrichtung, die oben als eigene Einheiten beschrieben wurden, folglich programm-basiert implementiert.

Die Steuervorrichtung 216 kann z.B. als ein Steuer-Computer ausgebildet sein, der über die entsprechende Datenschnittstelle 217 und eine Ausgabeschnittstelle 220 verfügt. Die Datenerfassungseinrichtung 215 ersetzt in der beispielhaften Prüfvorrichtung 200 die erste Datenerfassungseinrichtung 101 und die zweite Datenerfassungseinrichtung 106. Es werden also sowohl die Trainingsmesswerte als auch die Prüfmesswerte mit der Datenerfassungseinrichtung 215 erfasst.

Es versteht sich, dass in weiteren Ausführungsbeispielen der Prüfvorrichtungen 100, 200 zumindest einige der oben beschriebenen Elemente der Prüfvorrichtungen 100, 200 als Software bzw. Computerprogrammprodukt implementiert sein können, welche von einem Prozessor oder einer Recheneinrichtung ausgeführt werden. Ferner versteht sich, dass die einzelnen Elemente der Prüfvorrichtungen 100, 200 analog zu den oben beschriebenen Fortbildungen der entsprechenden Verfahrensschritte fortgebildet werden können.

Beispielsweise kann die Recheneinrichtung 103, 203 ausgebildet sein, beim Aufnehmen von Trainingsmesswerten 102 Messwerte an fehlerfreien Referenznetzwerken 150 aufzunehmen, und/oder Messwerte an Referenznetzwerken 150 aufzunehmen, in welchen an vorgegebenen Netzwerkabschnitten A - I, J - Q Fehler erzeugt wurden. Dazu kann z.B. in den entsprechenden Netzwerkabschnitten A - I, J - Q die Dielektrizitätskonstante um eine entsprechende Leitung des jeweiligen Netzwerks 151, 360, 461 verändert werden. Ferner kann die Recheneinrichtung 103, 203 ausgebildet sein, beim Vorverarbeiten der aufgenommenen Trainingsmesswerte 102 in den aufgenommenen Trainingsmesswerten 102 Ausreißer, insbesondere lokale Ausreißer oder globale Ausreißer, zu erkennen und zu eliminieren. Dazu kann z.B. die 2-Sigma-Regel oder der Ausreißertest nach Grubbs und Hampel oder der Local Outlier Factor Algorithmus genutzt werden. Die Recheneinrichtung 103, 203 kann ferner ausgebildet sein, beim Vorverarbeiten der aufgenommenen Trainingsmesswerte (102) in den aufgenommenen Trainingsmesswerten (102) Offsetfehler zu erkennen und zu eliminieren. Dazu können die aufgenommen Trainingsmesswerte 102 z.B. in differentielle Messwerte gewandelt werden. Die Recheneinrichtung 103, 203 kann auch ausgebildet sein, beim Vorverarbeiten der aufgenommenen Trainingsmesswerte 102 jeweils eine Mehrzahl, insbesondere 2, 4, 8, 16, 32 oder 64, einzelner Messkurven zu aggregieren.

Die Prüfsteuereinrichtung 108, 208 kann z.B. ausgebildet sein, beim Vorverarbeiten der aufgenommenen Prüfmesswerte 107 in den aufgenommenen Prüfmesswerte 107 Ausreißer, insbesondere lokale Ausreißer oder globale Ausreißer, zu erkennen und zu eliminieren. Dazu kann die 2-Sigma-Regel oder der Ausreißertest nach Grubbs und Hampel oder der Local Outlier Factor Algorithmus genutzt werden. Die Prüfsteuereinrichtung 108, 208 kann ferner ausgebildet sein, beim Vorverarbeiten der aufgenommenen Prüfmesswerte 107 in den aufgenommenen Prüfmesswerten 107 Offsetfehler zu erkennen und zu eliminieren. Die aufgenommen Prüfmesswerte 107 können dazu z.B. in differentielle Messwerte gewandelt werden. Die Prüfsteuereinrichtung 108, 208 kann ferner auch ausgebildet sein, beim Vorverarbeiten der aufgenommenen Prüfmesswerte 107 jeweils eine Mehrzahl, insbesondere 2, 4, 8, 16, 32 oder 64, einzelner Messkurven zu aggregieren.

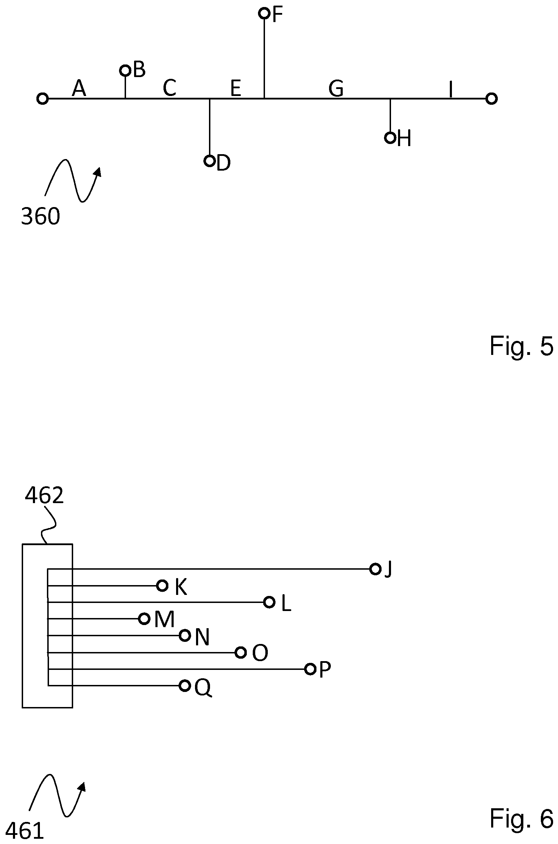

Figur 5 zeigt ein Netzwerk 360 zur Verwendung mit der vorliegenden Erfindung. Das Netzwerk 360 weist eine Busstruktur auf. Es besteht also aus einer durchgehenden Hauptleitung, an welche an vorgegebenen Stellen Stichleitungen zur Kontaktierung von Busteilnehmern vorgesehen sind. Ein solches Netzwerk kann z.B. die Basis eines CAN-Busses oder eines FlexRay-Busses in einem Fahrzeug bilden.

Bei dem Netzwerk 360 sind die einzelnen Segmente bzw. Netzwerkabschnitte A - I jeweils mit einem Buchstaben gekennzeichnet, wobei die Netzwerkabschnitte A, C, E, G und I die zentrale Hauptleitung bilden und die Netzwerkabschnitte B, D, F, H jeweils eine Stichleitung bezeichnen.

Impedanzänderungen in einem solchen Netzwerk 360 können insbesondere z.B. durch die Anbindung der Stichleitungen und auch durch Fehler in den einzelnen Leitungen des Netzwerks 360 entstehen.

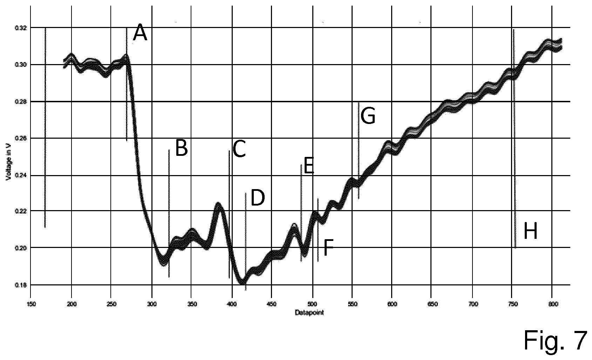

Die Aufnahme der Trainingsdaten bildet eine Art "Fingerabdruck" für das Netzwerk 360. Die vorliegende Erfindung ermöglicht es folglich, lediglich Netzwerke als fehlerhaft zu erkennen, bei welchen Impedanzänderungen tatsächlich durch Fehler hervorgerufen werden. Dass dies mit bloßem Auge nicht möglich ist, wird in Figur 7 deutlich, wo eine Messkurve für ein Netzwerk gezeigt ist, wie sie mit der vorliegenden Erfindung genutzt werden kann.

Figur 6 zeigt ein weiteres Netzwerk 461 zur Verwendung mit der vorliegenden Erfindung. Das Netzwerk 461 weist einen Sternkoppler 462 auf. Der Sternkoppler 462 bildet das zentrale Element bzw. den zentralen Verteiler des Netzwerks 461. Bei einem solchen Netzwerk 461 sind keine Stichleitungen vorhanden. Vielmehr sind alle Netzwerkabschnitte J - Q mit dem zentralen Sternkoppler 462 verbunden. Alle Leitungen bzw. Netzwerkabschnitte J - Q laufen folglich in dem Sternkoppler 462 zusammen.

Ein solches Netzwerk 461 kann z.B. ebenfalls die Basis für ein CAN-Busnetzwerk oder ein FlexRay-Netzwerk in einem Fahrzeug bilden. Die einzelnen Busteilnehmer sind dann an den Enden der einzelnen Netzwerkabschnitt J - Q angeschlossen.

Figur 7 zeigt ein Diagramm einer Messung an einem elektrischen Netzwerk 461.

Es ist zu erkennen, dass in der Messkurve zumindest die ersten Bewegungen der Amplituden (durch senkrechte Striche gekennzeichnet) noch einigermaßen nachvollziehbar sind. Grundsätzlich ist bei Erreichen des Sternkopplers 462 durch das Signal auf Grund Verteilung des Signals in alle Zweige ein Abfall der Amplitude zu erwarten (A). Ebenfalls ist ein anschließender Anstieg der Amplituden auf Grund der unterschiedlichen Längen der einzelnen Netzwerkabschnitt J - Q zu erwarten. Alle anderen Verlaufsmuster können allerdings nicht mehr gedeutet werden. Insbesondere können auf Grund der vielfältigen Überlagerungen optisch durch einen Benutzer keine Fehler in dem Netzwerk über die Messkurve identifiziert werden. Das Identifizieren von Fehlern in dem jeweiligen Netzwerk kann dagegen mit Hilfe der vorliegenden Erfindung sicher erfolgen.

### BEZUGSZEICHENLISTE

- 100,200: Prüfvorrichtung
- 101: erste Datenerfassungseinrichtung
- 102: Trainingsmesswerte
- 103, 203: Recheneinrichtung
- 104, 204: erstes Klassifikationssystem
- 105, 205: zweites Klassifikationssystem
- 106: zweite Datenerfassungseinrichtung
- 107: Prüfmesswerte
- 108, 208: Prüfsteuereinrichtung
- 109: erstes Klassifikationsergebnis
- 110: zweites Klassifikationsergebnis
- 215: Datenerfassungseinrichtung
- 216: Steuervorrichtung
- 217: Datenschnittstelle
- 218: Recheneinheit
- 219: Speicher
- 220: Ausgabeschnittstelle
- 150: Referenznetzwerk
- 151: Netzwerk
- 360: Netzwerk
- 461: Netzwerk
- 462: Sternknoten

- A - I, J - Q: Netzwerkabschnitt

- S1 - S8, S11, S12, S21: Verfahrensschritt
- S22, S23, S61, S62, S63: Verfahrensschritt

## Patentansprüche

1. Verfahren zum Prüfen eines Netzwerks (151, 360, 461) mit einer Anzahl von Netzwerkabschnitten (A - I, J - Q), insbesondere in einem Leitungssatz mit einer Anzahl solcher Netzwerke (151, 360, 461), mit den folgenden Schritten:
Aufnehmen (S1) von Trainingsmesswerten (102) für eine Anzahl von Referenznetzwerken (150), wobei die Referenznetzwerke (150) dem zu prüfenden Netzwerk (151, 360, 461) entsprechen,
Vorverarbeiten (S2) der aufgenommenen Trainingsmesswerte (102) zum Eliminieren von Datenfehlern in den Trainingsmesswerten (102),
Trainieren (S3) eines ersten Klassifikationssystems (104, 204) mit den Trainingsmesswerten (102), wobei das erste Klassifikationssystem (104, 204) auf mindestens einem Algorithmus aus dem Bereich des maschinellen Lernens basiert und ausgebildet ist, ein Netzwerk (151, 360, 461) entweder als fehlerfrei oder fehlerbehaftet zu klassifizieren,
Trainieren (S4) eines zweiten Klassifikationssystems (105, 205) mit den Trainingsmesswerten (102), wobei das zweite Klassifikationssystem (105, 205) auf mindestens einem Algorithmus aus dem Bereich des maschinellen Lernens basiert und ausgebildet ist, einen fehlerbehafteten Netzwerkabschnitt (A - I, J - Q) eines Netzwerks (151, 360, 461) zu klassifizieren,
Aufnehmen (S5) von Prüfmesswerten (107) für das zu prüfende Netzwerk (151, 360, 461),
Vorverarbeiten (S6) der aufgenommenen Prüfmesswerte (107) zum Eliminieren von Datenfehlern in den Trainingsmesswerten (102),
Klassifizieren (S7) des zu prüfenden Netzwerks (151, 360, 461) anhand der aufgenommenen Prüfmesswerte (107) mit dem trainierten ersten Klassifikationssystem (104, 204) als fehlerfrei oder fehlerbehaftet, und
Klassifizieren (S8) des fehlerbehafteten Netzwerkabschnitts (A - I, J - Q) des zu prüfenden Netzwerks (151, 360, 461) mit dem trainierten zweiten Klassifikationssystem (105, 205), wenn das zu prüfende Netzwerk (151, 360, 461) von dem trainierten ersten Klassifikationssystem (104, 204) als fehlerbehaftet klassifiziert wurde.

2. Verfahren nach Anspruch 1,
wobei das Aufnehmen (S1) von Trainingsmesswerten (102) das Aufnehmen (S11) von Messwerten an fehlerfreien Referenznetzwerken (150) aufweist, und
wobei das Aufnehmen (S1) von Trainingsmesswerten (102) das Aufnehmen (S12) von Messwerten an Referenznetzwerken (150) aufweist, in welchen an vorgegebenen Netzwerkabschnitten (A - I, J - Q) Fehler erzeugt wurden.

3. Verfahren nach Anspruch 2, wobei zum Erzeugen der Fehler in den entsprechenden Netzwerkabschnitten (A - I, J - Q) die Dielektrizitätskonstante um eine entsprechende Leitung des jeweiligen Netzwerks (151, 360, 461) verändert wird.

4. Verfahren nach einem der vorherigen Ansprüche, wobei das Vorverarbeiten (S2) der
aufgenommenen Trainingsmesswerte (102) aufweist, in den aufgenommenen Trainingsmesswerten (102) Ausreißer zu erkennen und zu eliminieren (S21), und/oder
wobei das Vorverarbeiten (S6) der aufgenommenen Prüfmesswerte (107) aufweist, in den aufgenommenen Prüfmesswerte (107) Ausreißer zu erkennen und zu eliminieren (S61).

5. Verfahren nach Anspruch 4, wobei das Erkennen von Ausreißern aufweist, lokale Ausreißer oder globale Ausreißer zu erkennen und zu behandeln.

6. Verfahren nach einem der Ansprüche 4 und 5, wobei das Erkennen von Ausreißern mittels der 2-Sigma-Regel oder mittels Ausreißertest nach Grubbs und Hampel oder mittels Local Outlier Factor Algorithmus durchgeführt wird.

7. Verfahren nach einem der vorherigen Ansprüche,
wobei das Vorverarbeiten (S2) der aufgenommenen Trainingsmesswerte (102) aufweist, in den aufgenommenen Trainingsmesswerten (102) Offsetfehler zu erkennen und zu eliminieren (S22), und/oder
wobei das Vorverarbeiten (S6) der aufgenommenen Prüfmesswerte (107) aufweist, in den aufgenommenen Prüfmesswerten (107) Offsetfehler zu erkennen und zu eliminieren (S62).

8. Verfahren nach Anspruch 7,
wobei das Erkennen und Eliminieren (S22) von Offsetfehlern aufweist, die aufgenommenen Trainingsmesswerte (102) in differentielle Messwerte zu wandeln, und/oder
wobei das Erkennen und Eliminieren (S62) von Offsetfehlern aufweist, die aufgenommenen Prüfmesswerte (107) in differentielle Messwerte zu wandeln.

9. Verfahren nach einem der vorherigen Ansprüche,
wobei das Vorverarbeiten (S2) der aufgenommenen Trainingsmesswerte (102) aufweist, jeweils eine Mehrzahl, insbesondere 2, 4, 8, 16, 32 oder 64, einzelner Messkurven zu aggregieren (S23), und/oder
wobei das Vorverarbeiten (S6) der aufgenommenen Prüfmesswerte (107) aufweist, jeweils eine Mehrzahl, insbesondere 2, 4, 8, 16, 32 oder 64, einzelner Messkurven zu aggregieren (S63).

10. Verfahren nach einem der vorherigen Ansprüche,
wobei das erste Klassifikationssystem (104, 204) auf einem Entscheidungsbaum-Algorithmus oder einem Algorithmus nach der Ensemble-Methode, insbesondere einem AdaBoost-Algorithmus, oder einem Algorithmus zur Logistischen Regression oder einem Naive-Bayes-Klassifikator Algorithmus oder einem K-Nächste-Nachbarn-Klassifikator Algorithmus oder einem Supportvektormaschinen-Algorithmus basiert, und/oder
wobei das zweite Klassifikationssystem (105, 205) auf einem Entscheidungsbaum-Algorithmus oder einem Algorithmus nach der Ensemble-Methode, insbesondere einem AdaBoost-Algorithmus, oder einem Algorithmus zur Logistischen Regression oder einem Naive-Bayes-Klassifikator Algorithmus oder einem K-Nächste-Nachbarn-Klassifikator Algorithmus oder einem Supportvektormaschinen-Algorithmus basiert

11. Verfahren nach Anspruch 10,
wobei für das erste Klassifikationssystem (104, 204) eine Parameteroptimierung durchgeführt wird, und/oder
wobei für das zweite Klassifikationssystem (105, 205) eine Parameteroptimierung durchgeführt wird.

12. Verfahren nach einem der vorherigen Ansprüche,
wobei beim Trainieren (S3) des ersten Klassifikationssystems (104, 204) ein vorgegebener Anteil, insbesondere zwischen 70% und 95%, der vorverarbeiteten Trainingsmesswerte (102) für das Training des ersten Klassifikationssystems (104, 204) genutzt wird und der verbleidende Anteil der vorverarbeiteten Trainingsmesswerte (102) für eine Verifikation des Trainings genutzt wird, und/oder
wobei beim Trainieren (S4) des zweiten Klassifikationssystems (105, 205) ein vorgegebener Anteil, insbesondere zwischen 70% und 95%, der vorverarbeiteten Trainingsmesswerte (102) für das Training des ersten Klassifikationssystems (104, 204) genutzt wird und der verbleidende Anteil der vorverarbeiteten Trainingsmesswerte (102) für eine Verifikation des Trainings genutzt wird.

13. Prüfvorrichtung (100, 200) zur Prüfung eines Netzwerks (151, 360, 461) mit einer Anzahl von Netzwerkabschnitten (A - I, J - Q), insbesondere in einem Leitungssatz mit einer Anzahl solcher Netzwerke (151, 360, 461), aufweisend:
eine erste Datenerfassungseinrichtung (101), welche ausgebildet ist, Trainingsmesswerte (102) für eine Anzahl von Referenznetzwerken (150) aufzunehmen, wobei die Referenznetzwerke (150) dem zu prüfenden Netzwerk (151, 360, 461) entsprechen,
eine Recheneinrichtung (103, 203), welche ausgebildet ist, die aufgenommenen Trainingsmesswerte (102) zum Eliminieren von Datenfehlern in den Trainingsmesswerten (102) vorzuverarbeiten,
ein erstes Klassifikationssystem (104, 204), welches auf mindestens einem Algorithmus aus dem Bereich des maschinellen Lernens basiert und ausgebildet ist, ein Netzwerk (151, 360, 461) entweder als fehlerfrei oder fehlerbehaftet zu klassifizieren,
wobei die Recheneinrichtung (103, 203) ferner ausgebildet ist, das erste Klassifikationssystem (104, 204) mit den Trainingsmesswerten (102) zu trainieren,
ein zweites Klassifikationssystem (105, 205), welches auf mindestens einem Algorithmus aus dem Bereich des maschinellen Lernens basiert und ausgebildet ist, einen fehlerbehafteten Netzwerkabschnitt (A - I, J - Q) eines Netzwerks (151, 360, 461) zu klassifizieren,
wobei die Recheneinrichtung (103, 203) ferner ausgebildet ist, das zweite Klassifikationssystem (105, 205) mit den Trainingsmesswerten (102) zu trainieren,
eine zweite Datenerfassungseinrichtung (106), welche ausgebildet ist, Prüfmesswerte (107) für das zu prüfende Netzwerk (151, 360, 461) aufzunehmen, und
einer Prüfsteuereinrichtung (108, 208), welche ausgebildet ist, die aufgenommenen Prüfmesswerte (107) zum Eliminieren von Datenfehlern in den Trainingsmesswerten (102) vorzuverarbeiten,
wobei die Prüfsteuereinrichtung (108, 208) ferner ausgebildet ist, das zu prüfende Netzwerk (151, 360, 461) anhand der aufgenommenen Prüfmesswerte (107) mit dem trainierten ersten Klassifikationssystem (104, 204) als fehlerfrei oder fehlerbehaftet zu klassifizieren, und
wobei die Prüfsteuereinrichtung (108, 208) ferner ausgebildet ist, den fehlerbehafteten Netzwerkabschnitt (A - I, J - Q) des zu prüfenden Netzwerks (151, 360, 461) mit dem trainierten zweiten Klassifikationssystem (105, 205) zu klassifizieren, wenn das zu prüfende Netzwerk (151, 360, 461) von dem trainierten ersten Klassifikationssystem (104, 204) als fehlerbehaftet klassifiziert wurde.

14. Prüfvorrichtung (100, 200) nach Anspruch 13,
wobei die Recheneinrichtung (103, 203) ausgebildet ist, beim Aufnehmen von Trainingsmesswerten (102) Messwerte an fehlerfreien Referenznetzwerken (150) aufzunehmen, und/oder
wobei die Recheneinrichtung (103, 203) ausgebildet ist, beim Aufnehmen von Trainingsmesswerten (102) Messwerte an Referenznetzwerken (150) aufzunehmen, in welchen an vorgegebenen Netzwerkabschnitten (A - I, J - Q) Fehler erzeugt wurden, wobei zum Erzeugen der Fehler in den entsprechenden Netzwerkabschnitten (A - I, J - Q) insbesondere die Dielektrizitätskonstante um eine entsprechende Leitung des jeweiligen Netzwerks (151, 360, 461) verändert wird, und/oder
wobei die Recheneinrichtung (103, 203) ausgebildet ist, beim Vorverarbeiten der aufgenommenen Trainingsmesswerte (102) in den aufgenommenen Trainingsmesswerten (102) Ausreißer, insbesondere lokale Ausreißer oder globale Ausreißer, zu erkennen und zu eliminieren, insbesondere mittels der 2-Sigma-Regel oder mittels Ausreißertest nach Grubbs und Hampel oder mittels Local Outlier Factor Algorithmus, und/oder
wobei die Recheneinrichtung (103, 203) ausgebildet ist, beim Vorverarbeiten der aufgenommenen Trainingsmesswerte (102) in den aufgenommenen Trainingsmesswerten (102) Offsetfehler zu erkennen und zu eliminieren, insbesondere indem sie die aufgenommenen Trainingsmesswerte (102) in differentielle Messwerte wandelt, und/oder
wobei die Recheneinrichtung (103, 203) ausgebildet ist, beim Vorverarbeiten der aufgenommenen Trainingsmesswerte (102) jeweils eine Mehrzahl, insbesondere 2, 4, 8, 16, 32 oder 64, einzelner Messkurven zu aggregieren, und/oder
wobei das erste Klassifikationssystem (104, 204) auf einem Entscheidungsbaum-Algorithmus oder einem Algorithmus nach der Ensemble-Methode, insbesondere einem AdaBoost-Algorithmus, oder einem Algorithmus zur Logistischen Regression oder einem Naive-Bayes-Klassifikator Algorithmus oder einem K-Nächste-Nachbarn-Klassifikator Algorithmus oder einem Supportvektormaschinen-Algorithmus basiert, wobei die Recheneinrichtung (103, 203) insbesondere ausgebildet ist, für das erste Klassifikationssystem (104, 204) eine Parameteroptimierung durchzuführen.

15. Prüfvorrichtung (100, 200) nach einem der vorherigen Ansprüche 13 und 14,
wobei die Prüfsteuereinrichtung (108, 208) ausgebildet ist, beim Vorverarbeiten der aufgenommenen Prüfmesswerte (107) in den aufgenommenen Prüfmesswerten (107) Ausreißer, insbesondere lokale Ausreißer oder globale Ausreißer, zu erkennen und zu eliminieren, insbesondere mittels der 2-Sigma-Regel oder mittels Ausreißertest nach Grubbs und Hampel oder mittels Local Outlier Factor Algorithmus, und/oder
wobei die Prüfsteuereinrichtung (108, 208) ausgebildet ist, beim Vorverarbeiten der aufgenommenen Prüfmesswerte (107) in den aufgenommenen Prüfmesswerten (107) Offsetfehler zu erkennen und zu eliminieren, insbesondere indem sie die aufgenommen Prüfmesswerte (107) in differentielle Messwerte wandelt, und/oder
wobei die Prüfsteuereinrichtung (108, 208) ausgebildet ist, beim Vorverarbeiten der aufgenommenen Prüfmesswerte (107) jeweils eine Mehrzahl, insbesondere 2, 4, 8, 16, 32 oder 64, einzelner Messkurven zu aggregieren, und/oder
wobei das zweite Klassifikationssystem (105, 205) auf einem Entscheidungsbaum-Algorithmus oder einem Algorithmus nach der Ensemble-Methode, insbesondere einem AdaBoost-Algorithmus, oder einem Algorithmus zur Logistischen Regression oder einem Naive-Bayes-Klassifikator Algorithmus oder einem K-Nächste-Nachbarn-Klassifikator Algorithmus oder einem Supportvektormaschinen-Algorithmus basiert, insbesondere wobei die Prüfsteuereinrichtung (108, 208) ausgebildet ist, für das zweite Klassifikationssystem (105, 205) eine Parameteroptimierung durchzuführen.

16. Computerprogrammprodukt, das dazu eingerichtet ist, das Verfahren gemäß einem der Ansprüche 1 bis 12 auszuführen, umzusetzen und/oder anzusteuern.

17. Maschinenlesbares Speichermedium, auf dem das Computerprogrammprodukt gemäß Anspruch 16 gespeichert ist.

## Claims

1. Method for testing a network (151, 360, 461) comprising a number of network sections (A - I, J - Q), in particular in a wiring harness comprising a number of such networks (151, 360, 461), comprising the following steps:
recording (S1) training measurement values (102) for a number of reference networks (150), the reference networks (150) corresponding to the network (151, 360, 461) to be tested,
preprocessing (S2) the recorded training measurement values (102) in order to eliminate data errors in the training measurement values (102),
training (S3) a first classification system (104, 204) with the training measurement values (102), the first classification system (104, 204) being based on at least one algorithm from the field of machine learning and being designed to classify a network (151, 360, 461) as either fault-free or faulty,
training (S4) a second classification system (105, 205) with the training measurement values (102), the second classification system (105, 205) being based on at least one algorithm from the field of machine learning and being designed to classify a faulty network section (A - I, J - Q) of a network (151, 360, 461),
recording (S5) test measurement values (107) for the network (151, 360, 461) to be tested,
preprocessing (S6) the recorded test measurement values (107) in order to eliminate data errors in the training measurement values (102),
classifying (S7) the network (151, 360, 461) to be tested as fault-free or faulty on the basis of the recorded test measurement values (107) with the trained first classification system (104, 204), and
classifying (S8) the faulty network section (A - I, J - Q) of the network (151, 360, 461) to be tested with the trained second classification system (105, 205) if the network (151, 360, 461) to be tested was classified as faulty by the trained first classification system (104, 204).

2. Method according to Claim 1,
wherein recording (S1) training measurement values (102) comprises recording (S11) measurement values on fault-free reference networks (150), and
wherein recording (S1) training measurement values (102) comprises recording (S12) measurement values on reference networks (150) in which faults were produced on predefined network sections (A - I, J - Q) .

3. Method according to Claim 2, wherein, in order to produce the faults in the corresponding network sections (A - I, J - Q), the dielectric constant around a corresponding line of the respective network (151, 360, 461) is changed.

4. Method according to any of the preceding claims,
wherein preprocessing (S2) the recorded training measurement values (102) comprises recognising and eliminating (S21) outliers in the recorded training measurement values (102), and/or
wherein preprocessing (S6) the recorded test measurement values (107) comprises recognising and eliminating (S61) outliers in the recorded test measurement values (107).

5. Method according to Claim 4, wherein recognising outliers comprises recognising and treating local outliers or global outliers.

6. Method according to either of Claims 4 and 5, wherein recognising outliers is carried out by means of the 2-sigma rule or by means of an outlier test according to Grubbs and Hampel or by means of a local outlier factor algorithm.

7. Method according to any of the preceding claims,
wherein preprocessing (S2) the recorded training measurement values (102) comprises recognising and eliminating (S22) offset errors in the recorded training measurement values (102), and/or
wherein preprocessing (S6) the recorded test measurement values (107) comprises recognising and eliminating (S62) offset errors in the recorded test measurement values (107).

8. Method according to Claim 7, wherein recognising and eliminating (S22) offset errors comprises converting the recorded training measurement values (102) into differential measurement values, and/or wherein recognising and eliminating (S62) offset errors comprises converting the recorded test measurement values (107) into differential measurement values.

9. Method according to any of the preceding claims,
wherein preprocessing (S2) the recorded training measurement values (102) comprises aggregating (S23) in each case a plurality of, in particular 2, 4, 8, 16, 32 or 64, individual measurement curves, and/or
wherein preprocessing (S6) the recorded test measurement values (107) comprises aggregating (S63) in each case a plurality of, in particular 2, 4, 8, 16, 32 or 64, individual measurement curves.

10. Method according to any of the preceding claims,
wherein the first classification system (104, 204) is based on a decision tree algorithm or an algorithm according to the ensemble method, in particular an AdaBoost algorithm, or an algorithm for logistic regression or a naive Bayes classifier algorithm or a K-nearest neighbours classifier algorithm or a support vector machine algorithm, and/or
wherein the second classification system (105, 205) is based on a decision tree algorithm or an algorithm according to the ensemble method, in particular an AdaBoost algorithm, or an algorithm for logistic regression or a naive Bayes classifier algorithm or a K-nearest neighbours classifier algorithm or a support vector machine algorithm.

11. Method according to Claim 10,
wherein a parameter optimization is carried out for the first classification system (104, 204), and/or
wherein a parameter optimization is carried out for the second classification system (105, 205).

12. Method according to any of the preceding claims,
wherein, during the process of training (S3) the first classification system (104, 204), a predefined proportion, in particular between 70% and 95%, of the preprocessed training measurement values (102) is used for the training of the first classification system (104, 204) and the remaining proportion of the preprocessed training measurement values (102) is used for a verification of the training, and/or
wherein, during the process of training (S4) the second classification system (105, 205), a predefined proportion, in particular between 70% and 95%, of the preprocessed training measurement values (102) is used for the training of the first classification system (104, 204) and the remaining proportion of the preprocessed training measurement values (102) is used for a verification of the training.

13. Test apparatus (100, 200) for testing a network (151, 360, 461) comprising a number of network sections (A - I, J - Q), in particular in a wiring harness comprising a number of such networks (151, 360, 461), comprising:
a first data acquisition device (101) designed to record training measurement values (102) for a number of reference networks (150), the reference networks (150) corresponding to the network (151, 360, 461) to be tested,
a computing device (103, 203) designed to preprocess the recorded training measurement values (102) in order to eliminate data errors in the training measurement values (102),
a first classification system (104, 204) based on at least one algorithm from the field of machine learning and designed to classify a network (151, 360, 461) as either fault-free or faulty,
wherein the computing device (103, 203) is furthermore designed to train the first classification system (104, 204) with the training measurement values (102),
a second classification system (105, 205) based on at least one algorithm from the field of machine learning and designed to classify a faulty network section (A - I, J - Q) of a network (151, 360, 461),
wherein the computing device (103, 203) is furthermore designed to train the second classification system (105, 205) with the training measurement values (102),
a second data acquisition device (106) designed to record test measurement values (107) for the network (151, 360, 461) to be tested, and
a test control device (108, 208) designed to preprocess the recorded test measurement values (107) in order to eliminate data errors in the training measurement values (102),
wherein the test control device (108, 208) is furthermore designed to classify the network (151, 360, 461) to be tested as fault-free or faulty on the basis of the recorded test measurement values (107) with the trained first classification system (104, 204), and
wherein the test control device (108, 208) is furthermore designed to classify the faulty network section (A - I, J - Q) of the network (151, 360, 461) to be tested with the trained second classification system (105, 205) if the network (151, 360, 461) to be tested was classified as faulty by the trained first classification system (104, 204).

14. Test apparatus (100, 200) according to Claim 13,
wherein the computing device (103, 203) is designed, during the process of recording training measurement values (102), to record measurement values on fault-free reference networks (150), and/or
wherein the computing device (103, 203) is designed, during the process of recording training measurement values (102), to record measurement values on reference networks (150) in which faults were produced on predefined network sections (A - I, J - Q), wherein, in order to produce the faults in the corresponding network sections (A - I, J - Q), in particular the dielectric constant around a corresponding line of the respective network (151, 360, 461) is changed, and/or
wherein the computing device (103, 203) is designed, during the process of preprocessing the recorded training measurement values (102), to recognise and eliminate outliers, in particular local outliers or global outliers, in the recorded training measurement values (102), in particular by means of the 2-sigma rule or by means of an outlier test according to Grubbs and Hampel or by means of a local outlier factor algorithm, and/or
wherein the computing device (103, 203) is designed, during the process of preprocessing the recorded training measurement values (102), to recognise and eliminate offset errors in the recorded training measurement values (102), in particular by converting the recorded training measurement values (102) into differential measurement values, and/or
wherein the computing device (103, 203) is designed, during the process of preprocessing the recorded training measurement values (102), to aggregate in each case a plurality of, in particular 2, 4, 8, 16, 32 or 64, individual measurement curves, and/or
wherein the first classification system (104, 204) is based on a decision tree algorithm or an algorithm according to the ensemble method, in particular an AdaBoost algorithm, or an algorithm for logistic regression or a naive Bayes classifier algorithm or a K-nearest neighbours classifier algorithm or a support vector machine algorithm, wherein the computing device (103, 203) is designed in particular to carry out a parameter optimization for the first classification system (104, 204).

15. Test apparatus (100, 200) according to either of the preceding Claims 13 and 14,
wherein the test control device (108, 208) is designed, during the process of preprocessing the recorded test measurement values (107), to recognise and eliminate outliers, in particular local outliers or global outliers, in the recorded test measurement values (107), in particular by means of the 2-sigma rule or by means of an outlier test according to Grubbs and Hampel or by means of a local outlier factor algorithm, and/or
wherein the test control device (108, 208) is designed, during the process of preprocessing the recorded test measurement values (107), to recognise and eliminate offset errors in the recorded test measurement values (107), in particular by converting the recorded test measurement values (107) into differential measurement values, and/or
wherein the test control device (108, 208) is designed, during the process of preprocessing the recorded test measurement values (107), to aggregate in each case a plurality of, in particular 2, 4, 8, 16, 32 or 64, individual measurement curves, and/or
wherein the second classification system (105, 205) is based on a decision tree algorithm or an algorithm according to the ensemble method, in particular an AdaBoost algorithm, or an algorithm for logistic regression or a naive Bayes classifier algorithm or a K-nearest neighbours classifier algorithm or a support vector machine algorithm, wherein the test control device (108, 208) is designed in particular to carry out a parameter optimization for the second classification system (105, 205).

16. Computer program product configured to carry out, implement and/or control the method according to any of Claims 1 to 12.

17. Machine-readable storage medium on which the computer program product according to Claim 16 is stored.

## Revendications

1. Procédé de contrôle d'un réseau (151, 360, 461) comprenant un certain nombre de portions de réseau (A-I, J-Q), notamment dans un jeu de lignes comprenant un certain nombre de tels réseaux (151, 360, 461), comprenant les étapes suivantes :
enregistrement (S1) de valeurs de mesure d'entraînement (102) pour un certain nombre de réseaux de référence (150), les réseaux de référence (150) correspondant au réseau (151, 360, 461) à contrôler,
prétraitement (S2) des valeurs de mesure d'entraînement (102) enregistrées en vue d'éliminer les erreurs de données dans les valeurs de mesure d'entraînement (102), entraînement (S3) d'un premier système de classification (104, 204) avec les valeurs de mesure d'entraînement (102), le premier système de classification (104, 204) se basant sur au moins un algorithme issu du domaine de l'apprentissage automatique et étant configuré pour classifier un réseau (151, 360, 461) comme étant exempt d'erreur ou défectueux,
entraînement (S4) d'un deuxième système de classification (105, 205) avec les valeurs de mesure d'entraînement (102), le deuxième système de classification (105, 205) se basant sur au moins un algorithme issu du domaine de l'apprentissage automatique et étant configuré pour classifier une portion de réseau (A-I, J-Q) défectueuse d'un réseau (151, 360, 461),
enregistrement (S5) de valeurs de mesure de contrôle (107) pour le réseau (151, 360, 461) à contrôler, prétraitement (S6) des valeurs de mesure de contrôle (107) enregistrées en vue d'éliminer les erreurs de données dans les valeurs de mesure d'entraînement (102),
classification (S7) du réseau (151, 360, 461) à contrôler à l'aide des valeurs de mesure de contrôle (107) enregistrées avec le premier système de classification (104, 204) entraîné comme étant exempt d'erreur ou défectueux, et
classification (S8) de la portion de réseau (A-I, J-Q) défectueuse du réseau (151, 360, 461) à contrôler avec le deuxième système de classification (105, 205) entraîné lorsque le réseau (151, 360, 461) à contrôler a été classifié comme défectueux par le premier système de classification (104, 204) entraîné.

2. Procédé selon la revendication 1,
l'enregistrement (S1) de valeurs de mesure d'entraînement (102) comprenant l'enregistrement (S11) de valeurs de mesure au niveau de réseaux de référence (150) exempts d'erreur, et
l'enregistrement (S1) de valeurs de mesure d'entraînement (102) comprenant l'enregistrement (S12) de valeurs de mesure au niveau de réseaux de référence (150) dans lesquels des erreurs ont été générées sur des portions de réseau (A-I, J-Q) prédéfinies.

3. Procédé selon la revendication 2, la constante diélectrique autour d'une ligne correspondante du réseau (151, 360, 461) respectif étant modifiée en vue de la génération des erreurs dans les portions de réseau (A-I, J-Q) correspondantes.

4. Procédé selon l'une des revendications précédentes,
le prétraitement (S2) des valeurs de mesure d'entraînement (102) enregistrées comprenant la reconnaissance et l'élimination (S21) de valeurs aberrantes dans les valeurs de mesure d'entraînement (102) enregistrées, et/ou
le prétraitement (S6) des valeurs de mesure de contrôle (107) enregistrées comprenant la reconnaissance et l'élimination (S61) de valeurs aberrantes dans les valeurs de mesure de contrôle (107) enregistrées.

5. Procédé selon la revendication 4, la reconnaissance de valeurs aberrantes comprenant la reconnaissance et le traitement de valeurs aberrantes locales ou de valeurs aberrantes globales.

6. Procédé selon l'une des revendications 4 et 5, la reconnaissance de valeurs aberrantes étant effectuée au moyen de la règle des deux sigma ou au moyen d'un test de valeur aberrante selon Grubbs et Hampel ou au moyen d'un algorithme du facteur d'observation aberrante locale.

7. Procédé selon l'une des revendications précédentes,
le prétraitement (S2) des valeurs de mesure d'entraînement (102) enregistrées comprenant la reconnaissance et l'élimination (S22) d'erreurs de décalage dans les valeurs de mesure d'entraînement (102) enregistrées, et/ou
le prétraitement (S6) des valeurs de mesure de contrôle (107) enregistrées comprenant la reconnaissance et l'élimination (S62) d'erreurs de décalage dans les valeurs de mesure de contrôle (107) enregistrées.

8. Procédé selon la revendication 7,
la reconnaissance et l'élimination (S22) d'erreurs de décalage comprenant la conversion des valeurs de mesure d'entraînement (102) enregistrées en valeurs de mesure différentielles, et/ou
la reconnaissance et l'élimination (S62) d'erreurs de décalage comprenant la conversion des valeurs de mesure de contrôle (107) enregistrées en valeurs de mesure différentielles.

9. Procédé selon l'une des revendications précédentes,
le prétraitement (S2) des valeurs de mesure d'entraînement (102) enregistrées comprenant l'agrégation (S23) respective d'une pluralité de, notamment de 2, 4, 8, 16, 32 ou 64, courbes de mesure individuelles, et/ou
le prétraitement (S6) des valeurs de mesure de contrôle (107) enregistrées comprenant l'agrégation (S63) respective d'une pluralité de, notamment de 2, 4, 8, 16, 32 ou 64, courbes de mesure individuelles.

10. Procédé selon l'une des revendications précédentes,
le premier système de classification (104, 204) se basant sur un algorithme d'arbre de décision ou un algorithme selon la méthode de l'ensemble, notamment un algorithme AdaBoost, ou un algorithme de régression logique ou un algorithme de classification naïve bayésienne ou un algorithme des k plus proches voisins ou un algorithme de machines à vecteurs de support, et/ou
le deuxième système de classification (105, 205) se basant sur un algorithme d'arbre de décision ou un algorithme selon la méthode de l'ensemble, notamment un algorithme AdaBoost, ou un algorithme de régression logique ou un algorithme de classification naïve bayésienne ou un algorithme des k plus proches voisins ou un algorithme de machines à vecteurs de support.

11. Procédé selon la revendication 10,
une optimisation des paramètres étant effectuée pour le premier système de classification (104, 204), et/ou
une optimisation des paramètres étant effectuée pour le deuxième système de classification (105, 205).

12. Procédé selon l'une des revendications précédentes,
une part prédéfinie, notamment entre 70 % et 95 %, des valeurs de mesure d'entraînement (102) prétraitées étant utilisée lors de l'entraînement (S3) du premier système de classification (104, 204) pour l'entraînement (S3) du premier système de classification (104, 204) et la part restante des valeurs de mesure d'entraînement (102) prétraitées étant utilisée pour une vérification de l'entraînement, et/ou
une part prédéfinie, notamment entre 70 % et 95 %, des valeurs de mesure d'entraînement (102) prétraitées étant utilisée lors de l'entraînement (S4) du deuxième système de classification (105, 205) pour l'entraînement (S3) du premier système de classification (104, 204) et la part restante des valeurs de mesure d'entraînement (102) prétraitées étant utilisée pour une vérification de l'entraînement.

13. Arrangement de contrôle (100, 200) pour le contrôle d'un réseau (151, 360, 461) comprenant un certain nombre de portions de réseau (A-I, J-Q), notamment dans un jeu de lignes comprenant un certain nombre de tels réseaux (151, 360, 461), possédant :
un dispositif d'acquisition de données (101), qui est configuré pour enregistrer des valeurs de mesure d'entraînement (102) pour un certain nombre de réseaux de référence (150), les réseaux de référence (150) correspondant au réseau (151, 360, 461) à contrôler,
un dispositif de calcul (103, 203), qui est configuré pour prétraiter les valeurs de mesure d'entraînement (102) enregistrées en vue d'éliminer les erreurs de données dans les valeurs de mesure d'entraînement (102), un premier système de classification (104, 204), qui se base sur au moins un algorithme issu du domaine de l'apprentissage automatique et qui est configuré pour classifier un réseau (151, 360, 461) comme étant exempt d'erreur ou défectueux,
le dispositif de calcul (103, 203) étant en outre configuré pour entraîner le premier système de classification (104, 204) avec les valeurs de mesure d'entraînement (102),
un deuxième système de classification (105, 205) qui se base sur au moins un algorithme issu du domaine de l'apprentissage automatique et qui est configuré pour classifier une portion de réseau (A-I, J-Q) défectueuse d'un réseau (151, 360, 461),
le dispositif de calcul (103, 203) étant en outre configuré pour entraîner le deuxième système de classification (105, 205) avec les valeurs de mesure d'entraînement (102),
un deuxième dispositif d'acquisition de données (106), qui est configuré pour enregistrer des valeurs de mesure de contrôle (107) pour le réseau (151, 360, 461) à contrôler,
un dispositif de commande de contrôle (108, 208), qui est configuré pour prétraiter les valeurs de mesure de contrôle (107) enregistrées en vue d'éliminer les erreurs de données dans les valeurs de mesure d'entraînement (102),
le dispositif de commande de contrôle (108, 208) étant en outre configuré pour classifier le réseau (151, 360, 461) à contrôler à l'aide des valeurs de mesure de contrôle (107) enregistrées avec le premier système de classification (104, 204) entraîné comme étant exempt d'erreur ou défectueux, et
le dispositif de commande de contrôle (108, 208) étant en outre configuré classifier la portion de réseau (A-I, J-Q) défectueuse du réseau (151, 360, 461) à contrôler avec le deuxième système de classification (105, 205) entraîné lorsque le réseau (151, 360, 461) à contrôler a été classifié comme défectueux par le premier système de classification (104, 204) entraîné.

14. Arrangement de contrôle (100, 200) selon la revendication 13,
le dispositif de calcul (103, 203) étant configuré pour, lors de l'enregistrement des valeurs de mesure d'entraînement (102), enregistrer valeurs de mesure au niveau de réseaux de référence (150) exempts d'erreur, et
le dispositif de calcul (103, 203) étant configuré pour, lors de l'enregistrement des valeurs de mesure d'entraînement (102), enregistrer des valeurs de mesure au niveau de réseaux de référence (150) dans lesquels des erreurs ont été générées sur des portions de réseau (AI, J-Q) prédéfinies, la constante diélectrique autour d'une ligne correspondante du réseau (151, 360, 461) respectif étant notamment modifiée en vue de la génération des erreurs dans les portions de réseau (A-I, J-Q) correspondantes,
le dispositif de calcul (103, 203) étant configuré pour, lors du prétraitement des valeurs de mesure d'entraînement (102) enregistrées, reconnaître et éliminer des valeurs aberrantes dans les valeurs de mesure d'entraînement (102) enregistrées, notamment des de valeurs aberrantes locales ou des valeurs aberrantes globales, notamment au moyen de la règle des deux sigma ou au moyen d'un test de valeur aberrante selon Grubbs et Hampel ou au moyen d'un algorithme du facteur d'observation aberrante locale, et/ou
le dispositif de calcul (103, 203) étant configuré pour, lors du prétraitement des valeurs de mesure de contrôle (107) enregistrées, reconnaître et éliminer des erreurs de décalage dans les valeurs de mesure d'entraînement (102) enregistrées, notamment en effectuant un conversion des valeurs de mesure d'entraînement (102) enregistrées en valeurs de mesure différentielles, et/ou le dispositif de calcul (103, 203) étant configuré pour, lors du prétraitement des valeurs de mesure de contrôle (107) enregistrées, agréger respectivement une pluralité de, notamment 2, 4, 8, 16, 32 ou 64, courbes de mesure individuelles, et/ou
le premier système de classification (104, 204) se basant sur un algorithme d'arbre de décision ou un algorithme selon la méthode de l'ensemble, notamment un algorithme AdaBoost, ou un algorithme de régression logique ou un algorithme de classification naïve bayésienne ou un algorithme des k plus proches voisins ou un algorithme de machines à vecteurs de support, le dispositif de calcul (103, 203) étant notamment configuré pour effectuer une optimisation des paramètres pour le premier système de classification (104, 204).

15. Arrangement de contrôle (100, 200) selon l'une des revendications précédentes 13 et 14,
le dispositif de commande de contrôle (108, 208) étant configuré pour, lors du prétraitement des valeurs de mesure de contrôle (107) enregistrées, reconnaître et éliminer des valeurs aberrantes dans les valeurs de mesure de contrôle (107) enregistrées, notamment des de valeurs aberrantes locales ou des valeurs aberrantes globales, notamment au moyen de la règle des deux sigma ou au moyen d'un test de valeur aberrante selon Grubbs et Hampel ou au moyen d'un algorithme du facteur d'observation aberrante locale, et/ou
le dispositif de commande de contrôle (108, 208) étant configuré pour, lors du prétraitement des valeurs de mesure de contrôle (107) enregistrées, reconnaître et éliminer des erreurs de décalage dans les valeurs de mesure de contrôle (107) enregistrées, notamment en effectuant une conversion des valeurs de mesure de contrôle (107) enregistrées en valeurs de mesure différentielles, et/ou
le dispositif de commande de contrôle (108, 208) étant configuré pour, lors du prétraitement des valeurs de mesure de contrôle (107) enregistrées, agréger respectivement une pluralité de, notamment 2, 4, 8, 16, 32 ou 64, courbes de mesure individuelles, et/ou
le deuxième système de classification (105, 205) se basant sur un algorithme d'arbre de décision ou un algorithme selon la méthode de l'ensemble, notamment un algorithme AdaBoost, ou un algorithme de régression logique ou un algorithme de classification naïve bayésienne ou un algorithme des k plus proches voisins ou un algorithme de machines à vecteurs de support, le dispositif de commande de contrôle (108, 208) étant notamment configuré pour effectuer une optimisation des paramètres pour le deuxième système de classification (105, 205).

16. Produit de programme informatique, qui est conçu pour mettre en œuvre et/ou commander le procédé selon l'une des revendications 1 à 12.

17. Support de mémorisation lisible par machine sur lequel est mémorisé le produit de programme informatique selon la revendication 16.
